# EUROPEAN PATENT APPLICATION

(11) **EP 4 727 279 A1**
(43) Date of publication of application: **15.04.2026**
(21) Application number: 25201599.5
(22) Date of filing: 11.09.2025
(51) Int. Cl.: H10B 12/00, H10D 30/67, H10D 64/66

(54) **THREE-DIMENSIONAL SEMICONDUCTOR DEVICE**

(30) Priority: 14.10.2024 KR 20240139761
(71) Applicant: Samsung Electronics Co., Ltd., Suwon-si, Gyeonggi-do 16677 (KR)
(72) Inventor: JEONG, Eulji, 16677 Suwon-si (KR); KIM, Sukhoon, 16677 Suwon-si (KR); NOH, Hyojung, 16677 Suwon-si (KR); LYU, Sungnam, 16677 Suwon-si (KR); YANG, Minwoo, 16677 Suwon-si (KR); HAN, Jaehun, 16677 Suwon-si (KR)
(74) Representative: Marks & Clerk LLP

(57) **Abstract**

A three-dimensional semiconductor device includes a semiconductor pattern (SP) spaced apart from a substrate (100) that extends in a first direction (D1) parallel to a bottom surface of the substrate (100), a word line (WL) that at least partially encloses the semiconductor pattern (SP) and extends in a second direction (D2), which is parallel to the bottom surface of the substrate (100) and is orthogonal to the first direction (D1), and a bit line (BL) on a first side surface (S1) of the semiconductor pattern (SP) that extends in a third direction (D3) perpendicular to the bottom surface of the substrate (100). The word line (WL) includes a gate dielectric layer (Gox) that at least partially encloses the semiconductor pattern (SP) and a gate electrode (GE) on the gate dielectric layer (Gox), and the gate electrode (GE) may include a metal liner pattern (SML) and a gate electrode pattern (GEP) on a side surface of the metal liner pattern (SML). The metal liner pattern (SML) may have a U-shaped structure.

## Description

### BACKGROUND OF THE INVENTION

The present disclosure relates to a three-dimensional semiconductor device and a method of fabricating the same, and in particular, to a three-dimensional semiconductor device with improved reliability and a high integration density.

Due to their small-sized, multifunctional, and/or low-cost characteristics, semiconductor devices are being esteemed as important elements in the electronics industry. The semiconductor devices are classified into a semiconductor memory device for storing data, a semiconductor logic device for processing data, and a hybrid semiconductor device including both memory and logic elements.

With the recent trend of high speed and low power consumption of electronic devices, semiconductor devices in the electronic devices may also be required to have high operating speeds and/or low operating voltages, and to satisfy this requirement, it is necessary to increase an integration density of the semiconductor device. However, as the integration density of the semiconductor device increases, the semiconductor device may suffer from deteriorated electrical characteristics and low production yield. Accordingly, many studies are being conducted to improve the electrical characteristics and production yield of semiconductor devices.

### SUMMARY

An embodiment of the inventive concept provides a three-dimensional semiconductor device with improved reliability.

According to an embodiment of the inventive concept, a three-dimensional semiconductor device includes a semiconductor pattern spaced apart from a substrate that extends in a first direction parallel to a bottom surface of the substrate, a word line that at least partially encloses the semiconductor pattern and extends in a second direction, which is parallel to the bottom surface of the substrate and is orthogonal to the first direction, and a bit line on a first side surface of the semiconductor pattern that extends in a third direction perpendicular to the bottom surface of the substrate. The word line includes a gate dielectric layer that at least partially encloses the semiconductor pattern and a gate electrode on the gate dielectric layer, and the gate electrode includes a metal liner pattern and a gate electrode pattern on a side surface of the metal liner pattern. The metal liner pattern has a U-shaped structure.

According to an embodiment of the inventive concept, a three-dimensional semiconductor device includes a semiconductor pattern spaced apart from a substrate that extends in a first direction parallel to a bottom surface of the substrate, a word line that at least partially encloses the semiconductor pattern and extends in a second direction, which is parallel to the bottom surface of the substrate and is orthogonal to the first direction, and a bit line that extends in a third direction perpendicular to the bottom surface of the substrate, on a first side surface of the semiconductor pattern. The word line includes a gate dielectric layer that at least partially encloses the semiconductor pattern and a gate electrode on the gate dielectric layer, and the gate electrode includes a metal liner pattern and a gate electrode pattern on a side surface of the metal liner pattern. The gate electrode pattern includes a material having a higher work function than the metal liner pattern, and the gate electrode pattern may have a uniform grain size and/ or the gate electrode pattern is a result of a selective growth process.

According to an embodiment of the inventive concept, a three-dimensional semiconductor device includes a first stack and a second stack, which are on a substrate and are adjacent to each other in a first direction parallel to a bottom surface of the substrate, and a data storage pattern between the first stack and the second stack. The first stack may include a first semiconductor pattern spaced apart from the substrate that extends in the first direction, a first word line, that at least partially encloses the first semiconductor pattern and extends in a second direction, which is parallel to the bottom surface of the substrate and is orthogonal to the first direction, a first bit line on a first side surface of the first semiconductor pattern and extends in a third direction perpendicular to the bottom surface of the substrate, and a capping pattern at a side of the first word line. The first word line may include a gate dielectric layer that at least partially encloses the first semiconductor pattern and a first gate electrode on the gate dielectric layer, and the first gate electrode includes a first metal liner pattern, which has a first work function, and a first gate electrode pattern, which is on a side surface of the first metal liner pattern and has a second work function. The first metal liner pattern extends from a top surface of the gate dielectric layer to a bottom surface of the gate dielectric layer via a side surface of the capping pattern, and the second work function is greater than the first work function.

At least some of the above and other features of the invention are set out in the claims.

### BRIEF DESCRIPTION OF THE DRAWINGS

FIG. 1 is a circuit diagram schematically illustrating a three-dimensional semiconductor device according to an embodiment of the inventive concept.
FIGS. 2A, 2B, and 2C are perspective views schematically illustrating a three-dimensional semiconductor device, according to an embodiment of the inventive concept.
FIG. 3 is a plan view illustrating a three-dimensional semiconductor device according to an embodiment of the inventive concept.
FIG. 4 is a perspective view illustrating semiconductor patterns, word lines, bit lines, and a data storage pattern of a three-dimensional semiconductor device according to an embodiment of the inventive concept.
FIG. 5A is a sectional view, which is taken along a line A-A' of FIG. 3.
FIG. 5B is a sectional view, which is taken along a line B-B' of FIG. 3.
FIG. 5C is a sectional view, which is taken along a line C-C' of FIG. 3.
FIG. 6 is an enlarged view illustrating a portion 'P1' of FIG. 5A.
FIG. 7A is a sectional view illustrating a three-dimensional semiconductor device according to another embodiment of the inventive concept and corresponding to the line A-A' of FIG. 3.
FIG. 7B is a sectional view illustrating a three-dimensional semiconductor device according to another embodiment of the inventive concept and corresponding to the line B-B' of FIG. 3.
FIG. 7C is a sectional view illustrating a three-dimensional semiconductor device according to another embodiment of the inventive concept and corresponding to the line C-C' of FIG. 3.
FIG. 8 is an enlarged view illustrating a portion 'P1' of FIG. 7A.
FIGS. 9, 10, 11A, 11B, 12, 13A, 13B, 14, 15, 16A,16B, 17A, 17B, 17C, 18, 19A, 19B, 19C, 20, 21, 22, 23A, 23B, 24A, 24B 24C, 25, 26A, 26B, 26C, and 27, 28, and 29 are diagrams illustrating a method of fabricating a three-dimensional semiconductor device, according to an embodiment of the inventive concept.

### DETAILED DESCRIPTION

Example embodiments of the inventive concepts will now be described more fully with reference to the accompanying drawings, in which example embodiments are shown. In the drawings, like reference numerals denote like elements, and repeated descriptions thereof are omitted. As used herein, the term "and/or" includes any and all combinations of one or more of the associated listed items. It is noted that aspects described with respect to one embodiment may be incorporated in different embodiments although not specifically described relative thereto. That is, all embodiments and/or features of any embodiments can be combined in any way and/or combination.

In a three-dimensional semiconductor device (3D DRAM) technique known to the inventors, when word lines are formed, a liner metal layer may be deposited and etched, for a multi-WF engineering, and then, processes of ALD-filling and etching a bulk metal may be performed to form the word lines. However, in this case, technical issues (e.g., a void, a seam, and a fourfold point failure) may occur in the word line, during the filling process. IN embodiments of the present invention, for example, as a result of a selective growth process, for example using the metal liner pattern as a seed layer, the gate electrode pattern can be grown in a specific direction and or with a uniform grain size. As a result, the material of the gate electrode pattern may have a uniform and continuous orientation.

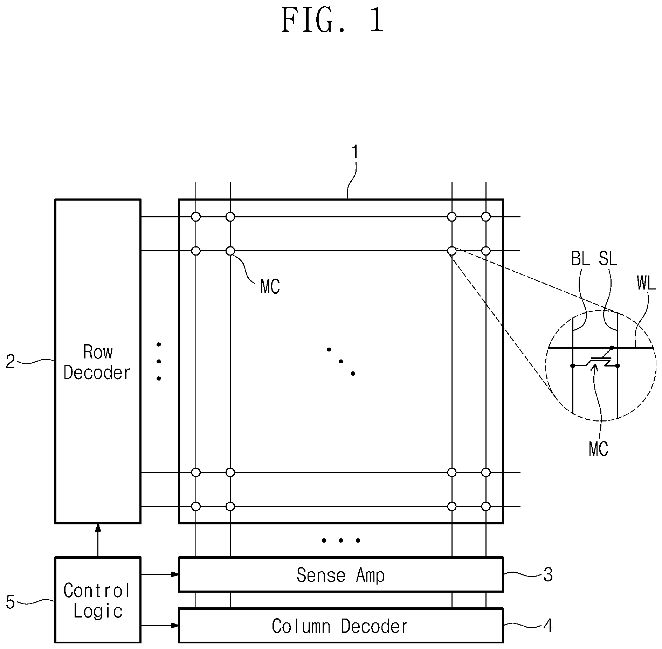

FIG. 1 is a circuit diagram schematically illustrating a three-dimensional semiconductor device according to an embodiment of the inventive concept.

Referring to FIG. 1, a three-dimensional semiconductor device may include a memory cell array 1, a row decoder 2, a sense amplifier 3, a column decoder 4, and a control logic 5.

The memory cell array 1 may include word lines WL, bit lines BL, source lines SL, and memory cells MC. The memory cells MC may be three-dimensionally arranged, and each memory cell MC may be connected to one of the word lines WL, one of the bit lines BL, and one of the source lines SL. In an embodiment, each of the memory cells MC may comprise one transistor including a memory layer or a data storing layer.

The row decoder 2 may be configured to decode address information, which is input from the outside (e.g., external to the three-dimensional semiconductor device), and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may be configured to establish a data transmission path between the sense amplifier 3 and an external device (e.g., a memory controller). The column decoder 4 may be configured to decode address information, which is input from the outside (e.g., external to the three-dimensional semiconductor device), and to select one of the bit lines BL, based on the decoded address information.

The control logic 5 may be configured to generate control signals, which are used to control data-writing or data-reading operations on the memory cell array 1.

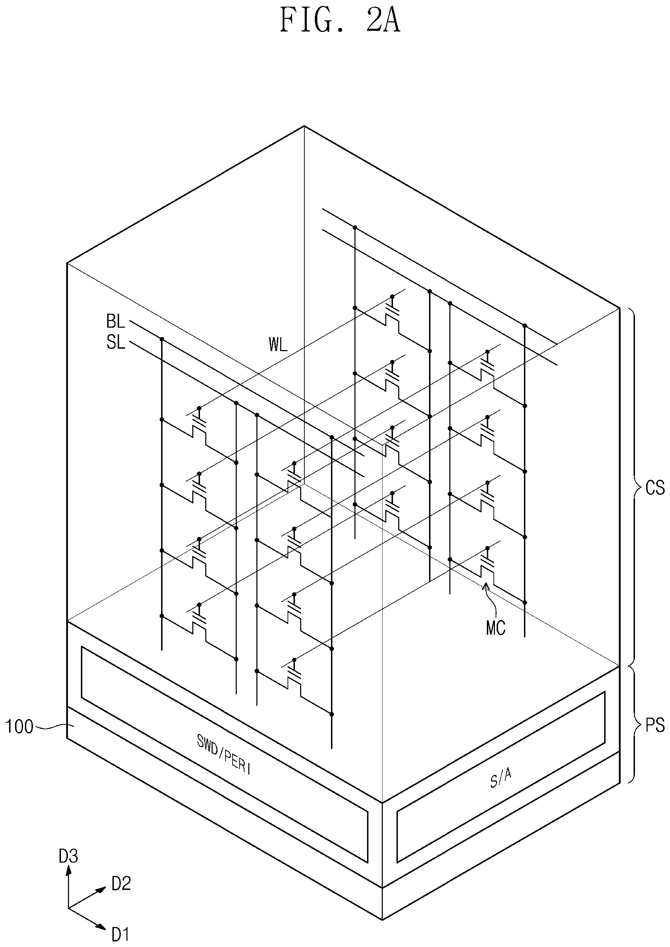

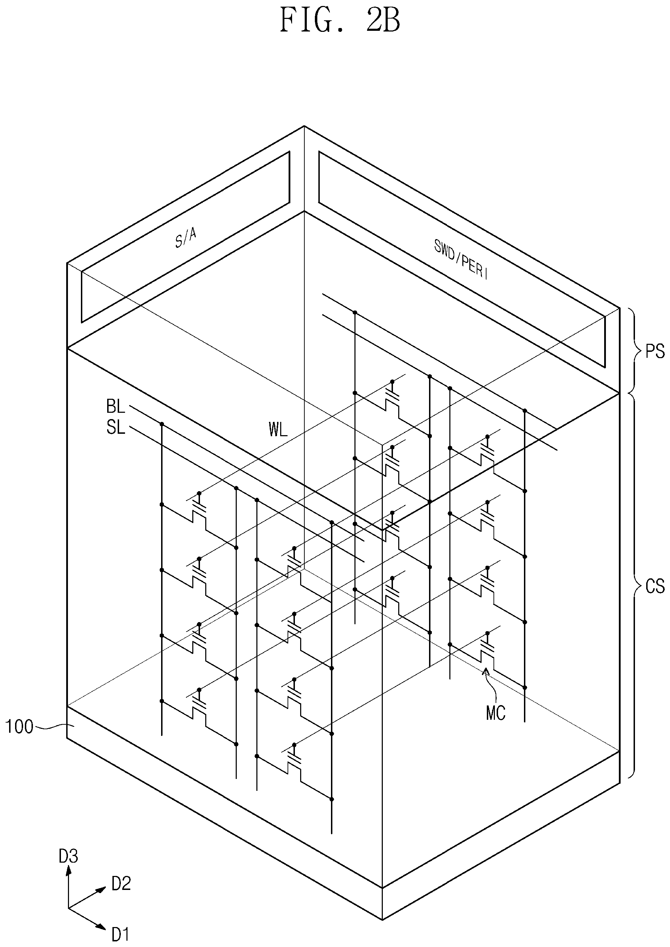

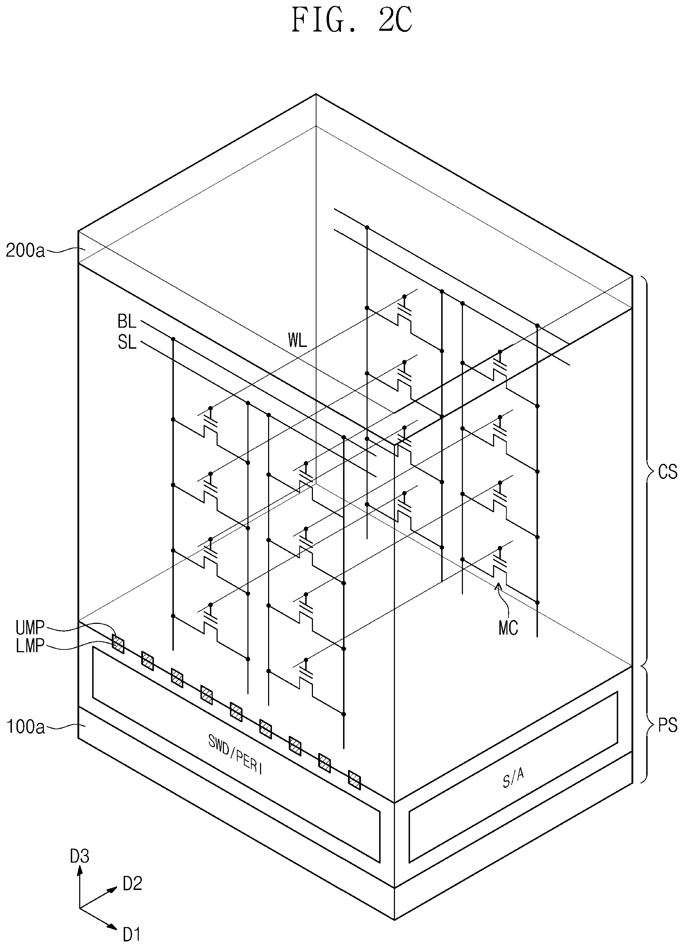

FIGS. 2A, 2B, and 2C are perspective views schematically illustrating a three-dimensional semiconductor device, according to an embodiment of the inventive concept.

Referring to FIG. 2A, three-dimensional semiconductor device may include a substrate 100, a peripheral circuit structure PS on the substrate 100, and a cell array structure CS on the peripheral circuit structure PS.

The peripheral circuit structure PS may include core and peripheral circuits, which are formed on the substrate 100. The core and peripheral circuits may include the row and column decoders 2 and 4, the sense amplifier 3, and the control logic 5 described with reference to FIG. 1.

The substrate 100 may be a plate-shaped structure that extends parallel to a plane defined by a first direction D1 and a second direction D2. The first and second directions D1 and D2 may be parallel to a bottom surface of the substrate 100 and may not be parallel to each other. As an example, the first and second directions D1 and D2 may be horizontal directions that are orthogonal to each other. The peripheral circuit structure PS and the cell array structure CS may be sequentially stacked on the substrate 100 in a third direction D3 perpendicular to the bottom surface of the substrate 100.

The cell array structure CS may include the bit lines BL, the source lines SL, the word lines WL, and the memory cells MC therebetween. Each of the memory cells MC may be electrically connected to one of the word lines WL, one of the bit lines BL, and one of the source lines SL.

Referring to FIG. 2B, the semiconductor device may include the cell array structure CS on the substrate 100 and the peripheral circuit structure PS on the cell array structure CS. The cell array structure CS may be disposed between the substrate 100 and the peripheral circuit structure PS. The peripheral circuit structure PS may include the core and peripheral circuits.

Referring to FIG. 2C, the semiconductor device may have a chip-to-chip (C2C) structure. The peripheral circuit structure PS may include a first substrate 100a. Lower metal pads LMP may be provided in the uppermost portion of the peripheral circuit structure PS. The lower metal pads LMP may be electrically connected to the core and peripheral circuits. The lower metal pads LMP may be bonded to upper metal pads UMP of the cell array structure CS.

The cell array structure CS may include a second substrate 200a, and the upper metal pads UMP may be provided in the lowermost portion of the cell array structure CS. The upper metal pads UMP may be electrically connected to the bit lines BL, the source lines SL, and the word lines WL. The upper metal pads UMP may be electrically connected to the memory cells MC.

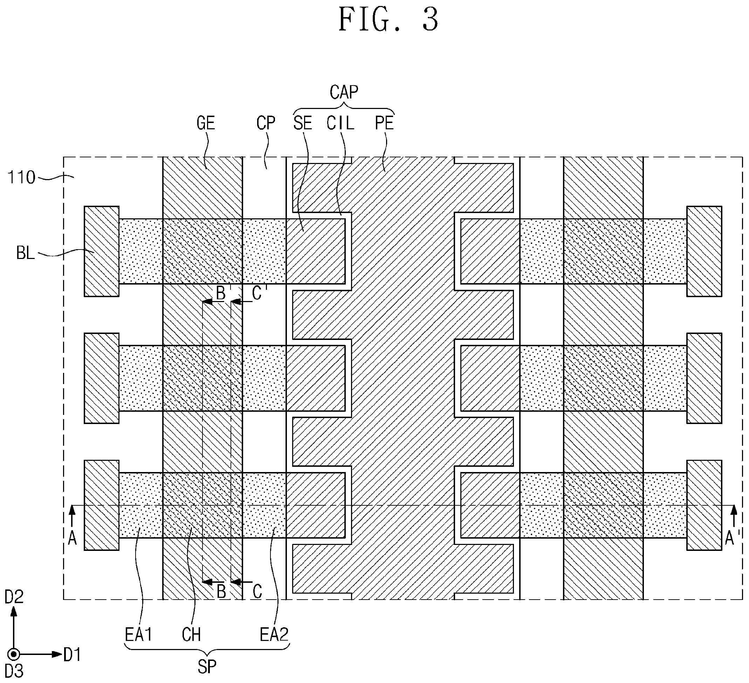

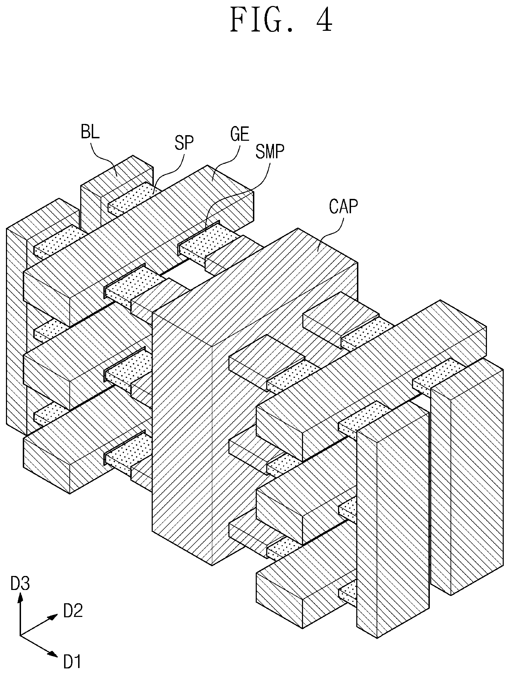

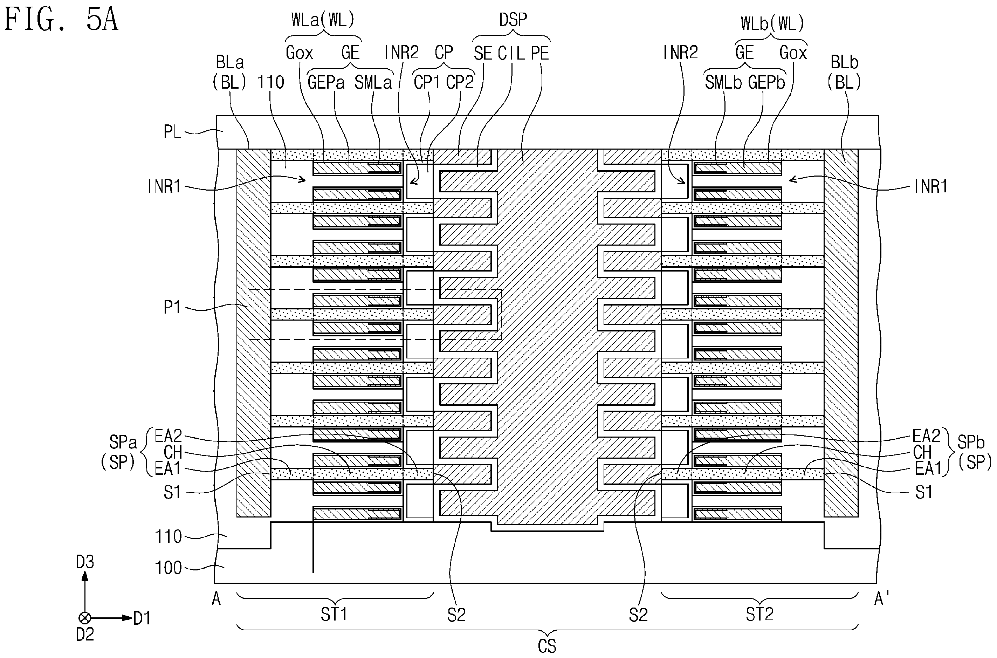

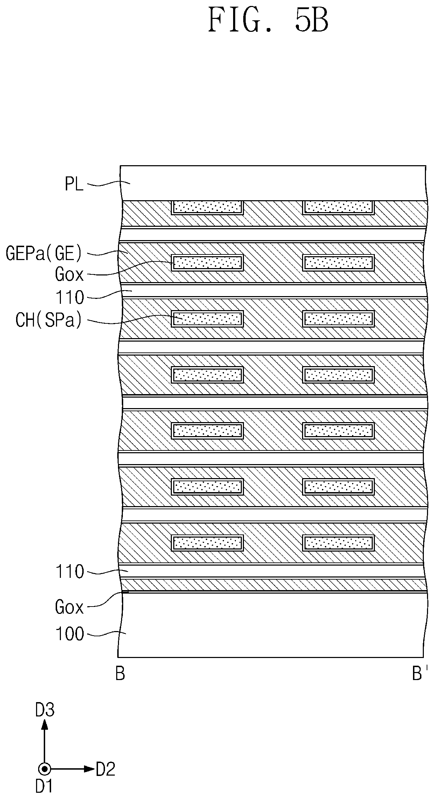

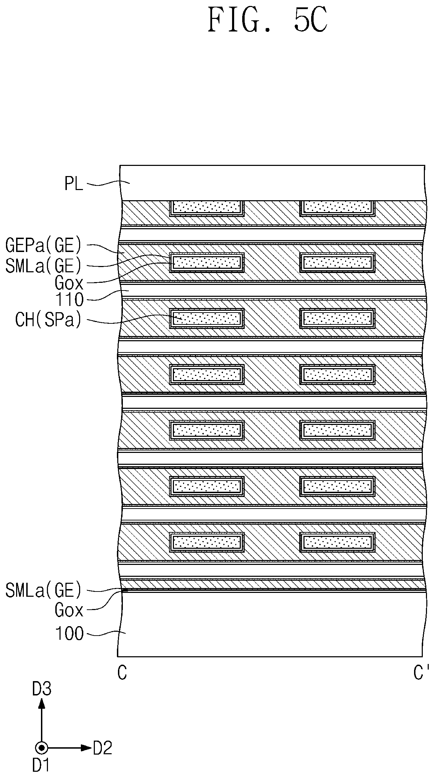

FIG. 3 is a plan view illustrating a three-dimensional semiconductor device according to an embodiment of the inventive concept. FIG. 4 is a perspective view illustrating semiconductor patterns, word lines, bit lines, and a data storage pattern of a three-dimensional semiconductor device according to an embodiment of the inventive concept. FIG. 5A is a sectional view, which is taken along a line A-A' of FIG. 3. FIG. 5B is a sectional view, which is taken along a line B-B' of FIG. 3. FIG. 5C is a sectional view, which is taken along a line C-C' of FIG. 3.

Referring to FIGS. 3 to 5C, the three-dimensional semiconductor device includes the substrate 100. The substrate 100 may be a semiconductor substrate, an insulating substrate, a silicon-on-insulator (SOI) substrate, or a germanium-on-insulator (GOI) substrate. The semiconductor substrate may be, for example, a silicon substrate, a germanium substrate, or a silicon-germanium substrate. The substrate 100 may be a plate-shaped structure that extends in the first and second directions D1 and D2.

The cell array structure CS may be provided on the substrate 100. The cell array structure CS may include a first stack ST1 and a second stack ST2, which are adjacent to each other in the first direction D1, and a data storage pattern DSP, which is provided therebetween. In an embodiment, although not shown, the cell array structure CS may include a plurality of cell array structures CS, which are adjacent to each other in the first direction D1. Hereinafter, just one cell array structure CS will be described, for brevity's sake, but the others of the cell array structures CS may also have substantially the same features as described below.

Each of the first and second stacks ST1 and ST2 may include semiconductor patterns SP, the word lines WL, the bit lines BL, first capping patterns CP1, second capping patterns CP2, and a gapfill insulating pattern 110. In an embodiment, the first and second stacks ST1 and ST2 may be provided to have a mirror symmetry with respect to the data storage pattern DSP.

The semiconductor pattern SP may extend in the first direction D1, on the substrate 100. In an embodiment, the semiconductor pattern SP may be a bar-shaped pattern, which extends in the first direction D1. The semiconductor pattern SP may be spaced apart from the substrate 100. That is, the semiconductor pattern SP may be floated from the substrate 100.

The semiconductor pattern SP may include a first edge portion EA1 and a second edge portion EA2, which are spaced apart from each other in the first direction D1, and a channel region CH, which is provided therebetween. The channel region CH of the semiconductor pattern SP may be at least partially surrounded by the word line WL as shown in FIGS. 5B and 5C. The first edge portion EA1 of the semiconductor pattern SP may be adjacent to the bit line BL. The first edge portion EA1 may be in contact with and electrically connected to the bit line BL. The second edge portion EA2 may be adjacent to the data storage pattern DSP. The second edge portion EA2 may be in contact with and electrically connected to the data storage pattern DSP.

The semiconductor pattern SP has a first side surface S1 and a second side surface S2, which are opposite to each other. The first and second side surfaces S1, S2, may also be called first and second ends. The first side surface S1 may be a side surface of the first edge portion EA1, and the second side surface S2 may be a side surface of the second edge portion EA2. The first side surface S1 of the semiconductor pattern SP is in contact with the bit line BL, and the second side surface S2 may be in contact with the data storage pattern DSP.

The semiconductor pattern SP may include at least one of a single crystalline semiconductor material, a polycrystalline semiconductor material, an oxide semiconductor material, and/or a two-dimensional material. In an embodiment, the single crystalline semiconductor material may be single crystalline silicon. In an embodiment, the polycrystalline semiconductor material may be poly silicon. In an embodiment, the oxide semiconductor material may be indium gallium zinc oxide (IGZO). In an embodiment, the two-dimensional material may be MoS₂, WS₂, MoSe₂, or WSe₂.

In an embodiment, each of the first and second edge portions EA1 and EA2 of the semiconductor pattern SP may include impurity regions doped with impurities (e.g., n- or p-type impurities). The impurity regions may constitute source /drain regions of a transistor.

In an embodiment, a plurality of semiconductor patterns SP may be provided. The semiconductor patterns SP may be adjacent to each other in the second and third directions D2 and D3. The semiconductor patterns SP, which are adjacent to each other in the third direction D3, may be vertically (D3 direction) overlapped with each other. The semiconductor patterns SP, which are adjacent to each other in the third direction D3, may have side surfaces that are aligned to each other.

The semiconductor pattern SP may include a first semiconductor pattern SPa provided in the first stack ST1 and a second semiconductor pattern SPb provided in the second stack ST2. The first semiconductor pattern SPa may be adjacent to the second semiconductor pattern SPb in the first direction D1. The first and second edge portions EA1 and EA2 of the first semiconductor pattern SPa may be sequentially disposed in the first direction D1. The first and second edge portions EA1 and EA2 of the second semiconductor pattern SPb may be sequentially disposed in the opposite direction of the first direction D1.

The word line WL may extend in the second direction D2 to enclose the channel region CH of the semiconductor pattern SP. In an embodiment, the word line WL may have a structure fully surrounding the channel region CH of the semiconductor pattern SP (i.e., a gate-all-around structure) in a cross-sectional view. The word line WL may be provided to enclose the channel region CH of each of the semiconductor patterns SP, which are adjacent to each other in the second direction D2. In an embodiment, a plurality of word lines WL may be provided. Each of the word lines WL may be provided to at least partially enclose the channel region CH of a corresponding one of the semiconductor patterns SP, which are adjacent to each other in the third direction D3, and may be extended in the second direction D2.

The word line WL may include a first word line WLa, which is provided in the first stack ST1 to at partially enclose the channel region CH of the first semiconductor pattern SPa, and a second word line WLb, which is provided in the second stack ST2 to at least partially enclose the channel region CH of the second semiconductor pattern SPb.

The word line WL may include a gate dielectric layer Gox, which is provided to at least partially enclose the channel region CH of the semiconductor pattern SP, and a gate electrode GE, which is provided on the gate dielectric layer Gox to at least partially enclose the channel region CH of the semiconductor pattern SP.

In an embodiment, the gate dielectric layer Gox may be formed of or include at least one of high-k dielectric materials, silicon oxide, silicon nitride, and/or silicon oxynitride and may be provided to have a single- or multi- layered structure. In the present specification, the high-k dielectric material may be defined as a material having a dielectric constant higher than silicon oxide.

The gate electrode GE may include a metal liner pattern SML, which has a first work function, and a gate electrode pattern GEP, which is provided on a side surface of the metal liner pattern SML to have a second work function. The metal liner pattern SML may be adjacent to the second edge portion EA2 of the semiconductor pattern SP, and the gate electrode pattern GEP may be adjacent to the first edge portion EA1 of the semiconductor pattern SP.

In an embodiment, the first work function of the metal liner pattern SML may be less than the second work function of the gate electrode pattern GEP. In addition, it may be possible to reduce a gate-induced leakage current (GIDL) phenomenon in the semiconductor pattern SP, when a three-dimensional semiconductor device is operated. As a result, an amount of holes accumulated in the semiconductor pattern SP may be reduced, and a leakage current caused by the holes may be reduced. Thus, the reliability of the three-dimensional semiconductor device may be improved.

The metal liner pattern SML may include a first material having a first work function. The gate electrode pattern GEP may include a second material having a second work function. The first material may include a material different from the second material. The work function of the first material may be less than the work function of the second material.

In an embodiment, the first material may include at least one of Li, Na, K, Cs, Rb, Sr, Ba, Ca, Ce, Sm, Eu, Mg, Sc, Y, Hf, Tl, As, La, Nd, Gd, Tb, Lu, Th, U, Mn, Al, Ga, In, Pb, Cd, Bi, Zr, Ti, TiN, and/or n-type doped poly Si. The second material may include at least one of Ti, TiN, TiSiN, TiON, W, WN, Mo, Ru, MoN, MoOₓN_{y}, Ta, TaN, and/or poly Si.

The gate electrode GE may include a first metal liner pattern SMLa and a first gate electrode pattern GEPa, which are provided in the first stack ST1 to at least partially enclose the channel region CH of the first semiconductor pattern SPa, and a second metal liner pattern SMLb and a second gate electrode pattern GEPb, which are provided in the second stack ST2 to at least partially enclose the channel region CH of the second semiconductor pattern SPb.

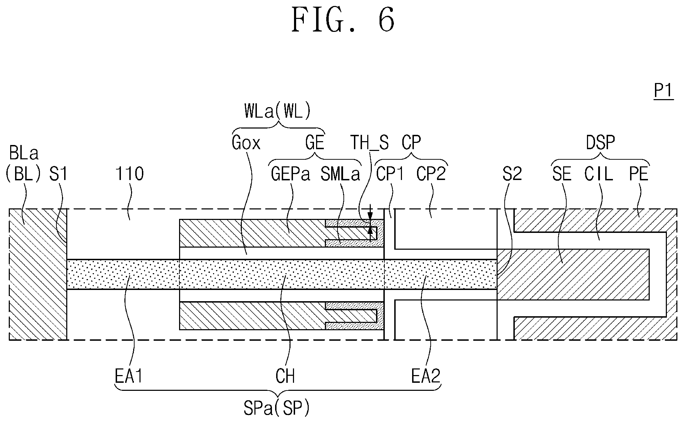

Hereinafter, the first metal liner pattern SMLa and the first gate electrode pattern GEPa according to an embodiment of the inventive concept will be described with reference to FIG. 6.

Referring to FIG. 6, the first metal liner pattern SMLa may extend along a top or bottom surface of the gate dielectric layer Gox. In detail, the first metal liner pattern SMLa may extend from the top surface of the gate dielectric layer Gox to the bottom surface of the gate dielectric layer Gox via a side surface of the first capping pattern CP1. The first metal liner pattern SMLa may be in contact with the gate dielectric layer Gox and the first capping pattern CP1. The first metal liner pattern SMLa may be a seed layer for forming the first gate electrode pattern GEPa.

The first metal liner pattern SMLa may have a U-shaped structure, when viewed in a sectional view. In detail, the first metal liner pattern SMLa may be a U-shaped liner pattern. The first metal liner pattern SMLa may be conformally formed. The first metal liner pattern SMLa may have a first thickness TH_S in the third direction D3. For example, the first thickness TH_S may range from 1 to 50 Å. Although not shown, the second metal liner pattern SMLb may have a U-shaped structure, when viewed in a sectional view. For example, the second metal liner pattern SMLb may have a U-shaped structure that is opposite to the first metal liner pattern SMLa. The second metal liner pattern SMLb may have a second thickness that is constant, and the second thickness may be equal to the first thickness TH_S.

The first gate electrode pattern GEPa may be a conductive pattern, which is formed using the first metal liner pattern SMLa as a seed layer. The first gate electrode pattern GEPa may be in and at least partially fill an inner region of the first metal liner pattern SMLa having a U-shaped structure. In detail, the first gate electrode pattern GEPa may include a first portion at least partially enclosed by the first metal liner pattern SMLa and a second portion at least partially enclosed by the gate dielectric layer Gox. A height of the second portion may be greater than a height of the first portion. The height may be defined as a vertical distance between top and bottom surfaces measured in the third direction D3. The first metal liner pattern SMLa may not be provided on top and bottom surfaces of the second portion.

The first gate electrode pattern GEPa may have a uniform grain size. The first gate electrode pattern GEPa may be formed of or include a second material having a uniform and continuous orientation. For example, the first gate electrode pattern GEPa may have an orientation in the first direction D1. The orientation may be defined as a ratio of a content of the second material, which is included in the first gate electrode pattern GEPa and is oriented in a specific direction (e.g., in the first direction D1), to a total content of several materials in the first gate electrode pattern GEPa. Here, in the case where the second material is formed of poly crystalline, the orientation may be defined as the orientation distribution of the grain.

According to an embodiment of the inventive concept, because the first gate electrode pattern GEPa is formed by growing a layer in a specific direction using the first metal liner pattern SMLa as a seed layer, the pattern failure in the gate electrode may be reduced. As a result, it may be possible to reduce an interconnection resistance of the gate electrode and consequently improve the reliability of the three-dimensional semiconductor device.

Referring back to FIGS. 3 to 5C, the bit line BL may be provided on the first side surface S1 of the semiconductor pattern SP (i.e., the side surface of the first edge portion EA1). The bit line BL may extend in the third direction D3, on the first side surface S1 of the semiconductor pattern SP. Thus, each of the bit lines BL may be in contact with and electrically connected to the first side surface S1 of each of the semiconductor patterns SP, which are adjacent to each other in the third direction D3. In an embodiment, a plurality of bit lines BL may be provided. The bit lines BL may be adjacent to each other in the second direction D2.

The bit line BL may be a single layer, which is made of a single material, or a composite layer including two or more materials. In an embodiment, the bit line BL may be formed of or include at least one or more metallic materials (e.g., Ti, Mo, W, Cu, Al, Ta, Ru, Ir, or Co), one or more metal nitride materials (e.g., containing Ti, Mo, W, Cu, Al, Ta, Ru, Ir, or Co), and/or one or more metal silicide materials (e.g., containing Ti, Mo, W, Cu, Al, Ta, Ru, Ir, or Co).

The bit line BL may include a first bit line BLa, which is provided in the first stack ST1 and on the first side surface S1 of the first semiconductor pattern SPa, and a second bit line BLb, which is provided in the second stack ST2 and on the first side surface S1 of the second semiconductor pattern SPb.

The data storage pattern DSP may be interposed between the first and second stacks ST1 and ST2. The data storage pattern DSP may be interposed between the first and second semiconductor patterns SPa and SPb. The data storage pattern DSP may be in contact with the second side surface S2 of the first semiconductor pattern SPa (i.e., the side surface of the second edge portion EA2) and may be electrically connected to the first semiconductor pattern SPa. The data storage pattern DSP may be in contact with the second side surface S2 of the second semiconductor pattern SPb and may be electrically connected to the second semiconductor pattern SPb.

The data storage pattern DSP may include a storage electrode SE, a plate electrode PE, and a capacitor dielectric layer CIL therebetween. In an embodiment, the three-dimensional semiconductor device may be a dynamic random access memory (DRAM) device, and here, the data storage pattern DSP may be used as a capacitor. The storage electrode SE may be spaced apart from the plate electrode PE by the capacitor dielectric layer CIL.

Each of the storage and plate electrodes SE and PE may include a conductive material. In an embodiment, each of the storage and plate electrodes SE and PE may be formed of or include at least one of doped silicon (Si), doped silicon germanium (SiGe), metallic materials (e.g., Ti, Mo, W, Cu, Al, Ta, Ru, Ir, Co, Pt, Au, and Ag), metal nitride materials (e.g., nitride materials containing Ti, Mo, W, Cu, Al, Ta, Ru, Ir, Co, Pt, Au, and Ag), titanium silicon nitride (e.g., TiSiN), titanium aluminum nitride (e.g., TiAlN), tantalum aluminum nitride (e.g., TaAlN), conductive oxide materials (e.g., PtO, RuO₂, IrO₂, SrRuO₃ (SRO), (Ba,Sr)RuO₃ (BSRO), CaRuO₃ (CRO), and LSCo), and/or metal silicide materials. Each of the storage and plate electrodes SE and PE may be a single layer, which is made of a single material, or a composite layer including two or more materials.

In an embodiment, the capacitor dielectric layer CIL may include at least one of metal oxide materials (e.g., HfO₂, ZrO₂, Al₂O₃, La₂O₃, Ta₂O₃, and TiO₂) and/or perovskite dielectric materials (e.g., SrTiO₃ (STO), (Ba,Sr)TiO₃ (BST), BaTiO₃, PZT, and PLZT).

In another embodiment, the data storage pattern DSP may be a variable resistance pattern whose resistance can be switched to one of at least two states by an electric pulse applied thereto. For example, the data storage pattern DSP may be formed of or include at least one of phase-change materials whose crystal state can be changed depending on an amount of a current applied thereto, perovskite compounds, transition metal oxides, magnetic materials, ferromagnetic materials, and/or antiferromagnetic materials.

The storage electrode SE may extend along the second side surface S2 of the first semiconductor pattern SPa and in the first direction D1. The storage electrode SE may be extended in an opposite direction of the first direction D1, on the second side surface S2 of the second semiconductor pattern SPb. Although not shown, a silicide pattern (not shown) may be provided between the storage electrode SE and the first semiconductor pattern SPa and between the storage electrode SE and the second semiconductor pattern SPb. The silicide pattern may be formed of or include one or more metal silicide materials (e.g., containing Ti, Mo, W, Cu, Al, Ta, Ru, Ir, and/or Co). In an embodiment, a plurality of storage electrodes SE may be provided, and here, the storage electrodes SE may be adjacent to each other in the third direction D3.

The plate electrode PE may include a first region, which extends in the third direction D3, and a second region, which extends from the first region to protrude in the first direction D1 or the opposite direction of the first direction D1. The second region of the plate electrode PE may be interposed between the storage electrodes SE, which are adjacent to each other in the third direction D3.

The gapfill insulating pattern 110 may be provided on the substrate 100. The gapfill insulating pattern 110 may be on and at least partially cover a side surface of the cell array structure CS. The gapfill insulating pattern 110 may be interposed between the bit line BL and the word line WL, between the semiconductor patterns SP, which are adjacent to each other in the third direction D3, between the first edge portions EA1 of the semiconductor patterns SP, which are adjacent to each other in the second direction D2, and between the word lines WL, which are adjacent to each other in the third direction D3. The gapfill insulating pattern 110 may include a single or composite layer including an insulating material.

A capping pattern CP may be provided in the cell array structure CS. The capping pattern CP may be interposed between the word lines WL and the data storage pattern DSP. The capping pattern CP may be interposed between the semiconductor patterns SP, which are adjacent to each other in the third direction D3. The capping pattern CP may be interposed between the second edge portions EA2 of the semiconductor patterns SP, which are adjacent to each other in the second direction D2.

The capping pattern CP may include a first capping pattern CP1 at least partially enclosing the second edge portion EA2 of the semiconductor pattern SP and a second capping pattern CP2 on the first capping pattern CP1. The first capping pattern CP1 may conformally at least partially cover the second edge portion EA2 of the semiconductor pattern SP and a side surface of the word line WL. Each of the first and second capping patterns CP1 and CP2 may include an insulating material. The second capping pattern CP2 may include a single or composite layer.

A protection layer PL may be provided on the cell array structure CS. The protection layer PL may be on and at least partially cover top surfaces of the first stack ST1, the second stack ST2, and the data storage pattern DSP. The protection layer PL may include a single or composite layer including an insulating material. The protection layer PL may include a plurality of upper interconnection lines (not shown) provided therein. Some of the upper interconnection lines may be electrically connected to the bit line BL and the data storage pattern DSP, respectively. In addition, although not shown, word line pads (not shown) may be provided on the side surface of the cell array structure CS and may be electrically connected to the word lines WL.

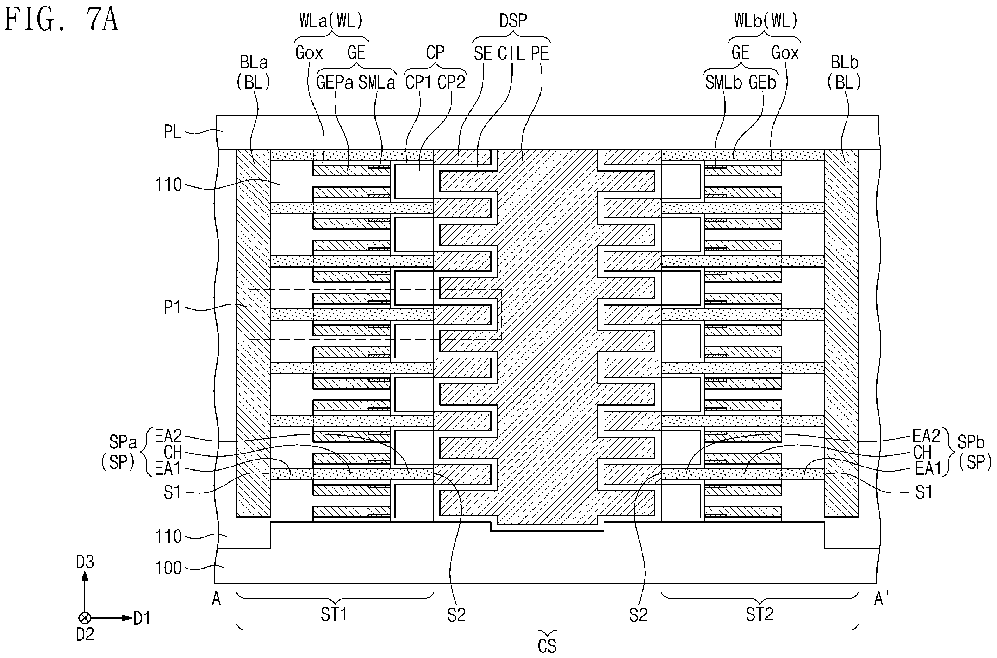

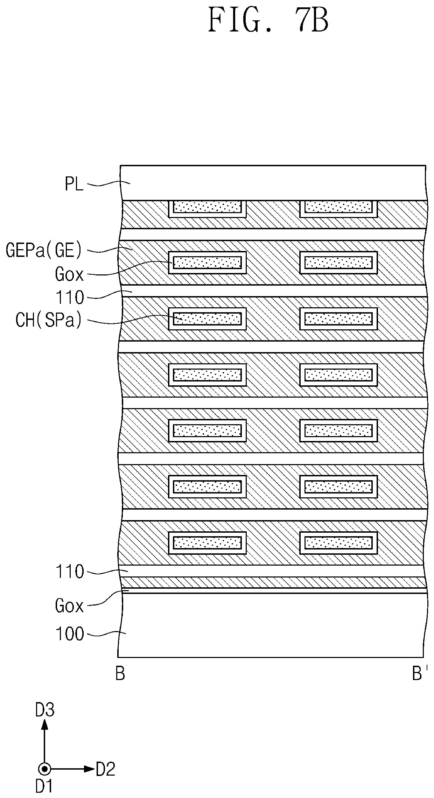

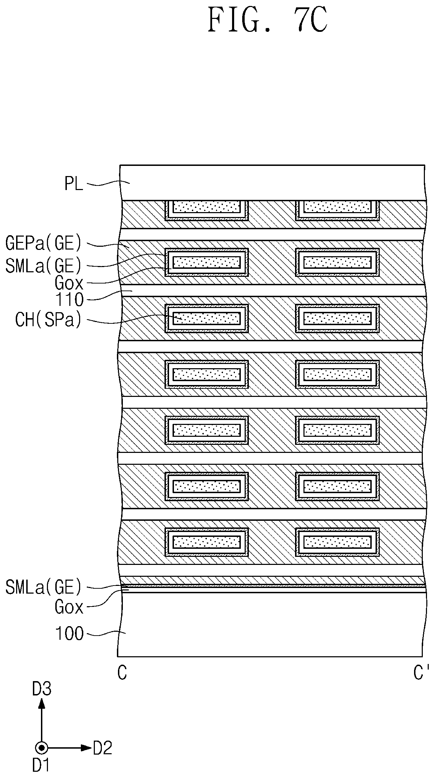

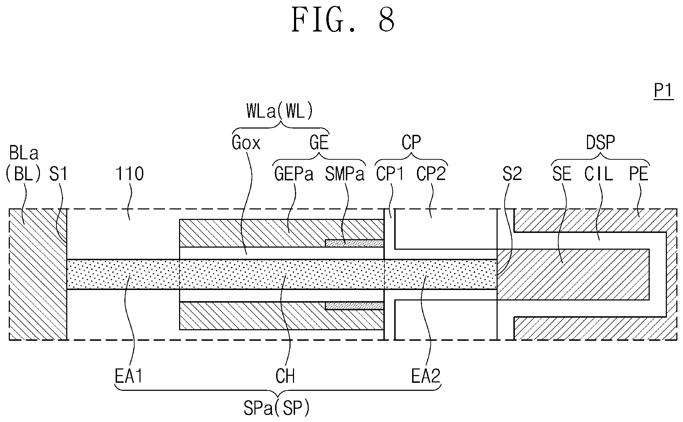

FIGS. 7A to 7C are sectional views illustrating a three-dimensional semiconductor device according to an embodiment of the inventive concept and corresponding to an embodiment different from FIGS. 5A to 5C. FIG. 7A is a sectional view taken along a line A-A' of FIG. 3. FIG. 7B is a sectional view illustrating a three-dimensional semiconductor device according to another embodiment of the inventive concept and corresponding to the line B-B' of FIG. 3. FIG. 7C is a sectional view illustrating a three-dimensional semiconductor device according to another embodiment of the inventive concept and corresponding to the line C-C' of FIG. 3. FIG. 8 is an enlarged view illustrating a portion 'P1' of FIG. 7A. In the following description, a previously-described element may be identified by the same reference number without repeating an overlapping description thereof, for concise description.

Referring to FIGS. 7A to 7C and FIG. 8, the word line WL may extend in the second direction D2 to at least partially enclose the channel region CH of the semiconductor pattern SP. In an embodiment, the word line WL may have a structure fully surrounding the channel region CH of the semiconductor pattern SP (i.e., a gate-all-around structure) in a cross-sectional view. The word line WL may be provided to at least partially enclose the channel region CH of each of the semiconductor patterns SP, which are adjacent to each other in the second direction D2. In an embodiment, a plurality of word lines WL may be provided. Each of the word lines WL may be provided to enclose the channel region CH of a corresponding one of the semiconductor patterns SP, which are adjacent to each other in the third direction D3, and may extend in the second direction D2.

The first metal liner pattern SMLa of the first word line WLa may be provided on a top surface of the first gate electrode pattern GEPa or a bottom surface of the first gate electrode pattern GEPa by a fabrication method to be described below. That is, the first metal liner pattern SMLa may have a bar-shaped structure extending in the first direction D1, not a U-shaped structure.

The first metal liner pattern SMLa may be provided on a portion of a top or bottom surface of the gate dielectric layer Gox with the channel region CH interposed therebetween.

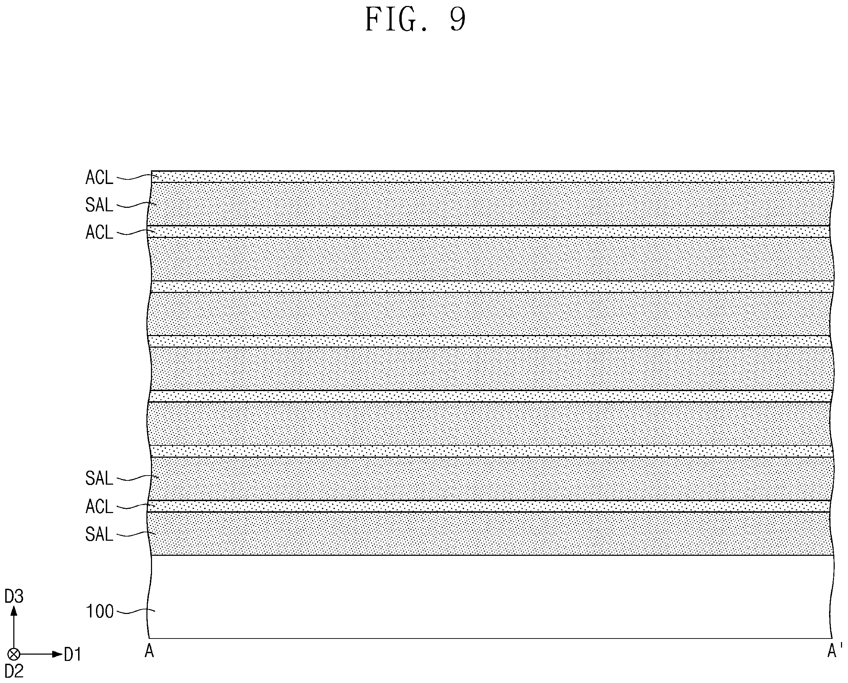

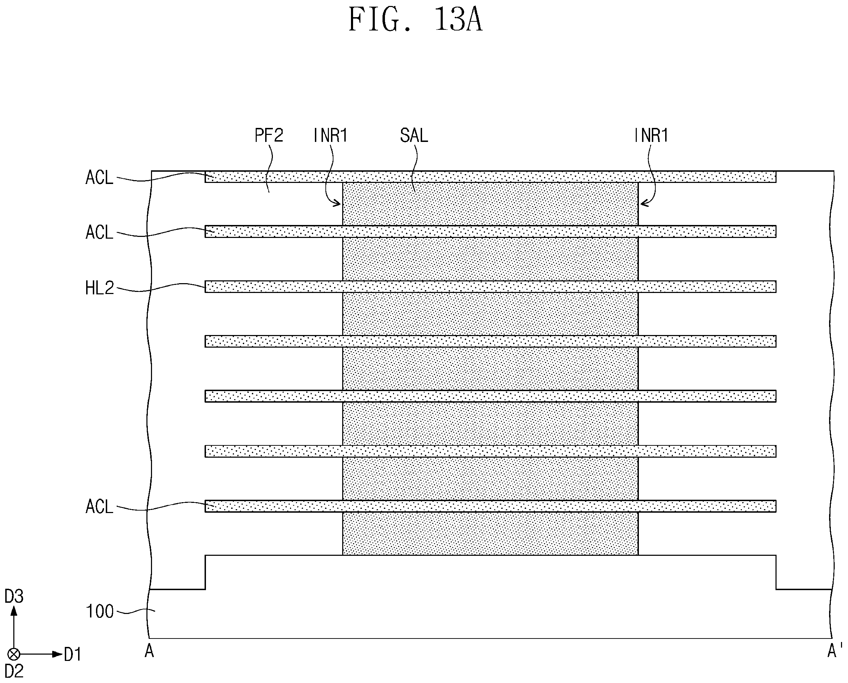

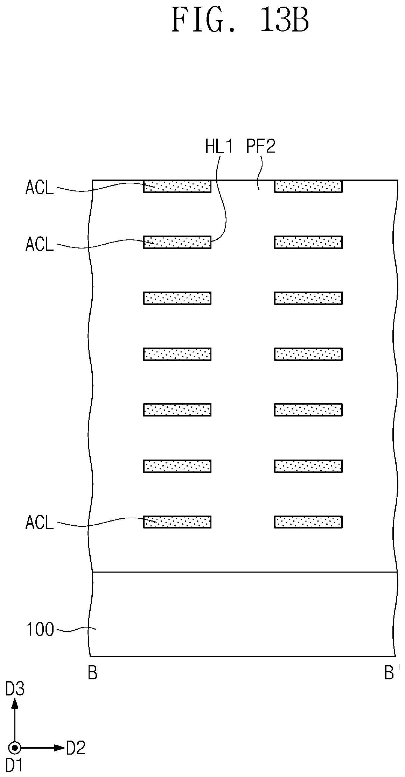

Hereinafter, a method of fabricating a three-dimensional semiconductor device, according to an embodiment of the inventive concept, will be described in more detail with reference to FIGS. 9, 10, 11A, 11B, 12, 13A, 13B, 14, 15, 16A,16B, 17A, 17B, 17C, 18, 19A, 19B, 19C, 20 - 22, 23A, 23B, 24, 25, 26A, 26B, 26C, and 27 - 29. In the following description, a previously-described element may be identified by the same reference number without repeating an overlapping description thereof, for concise description.

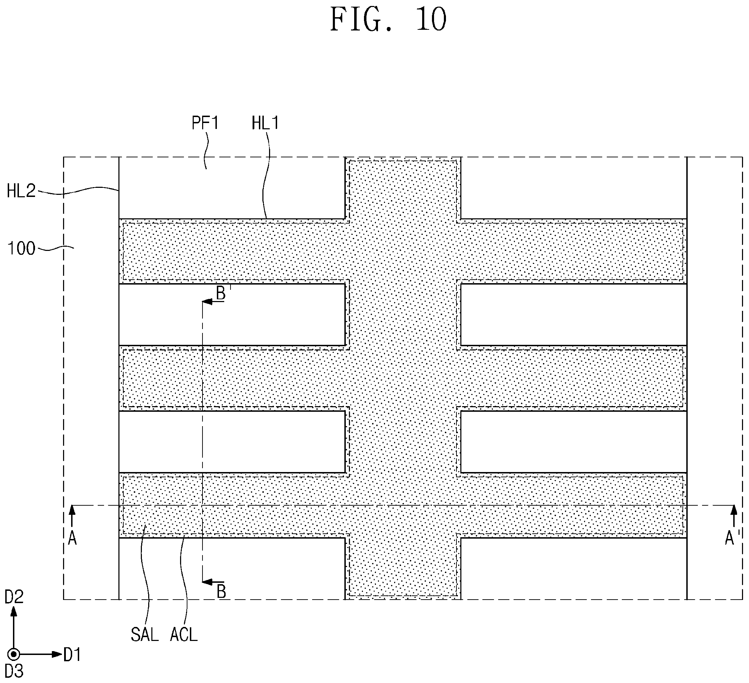

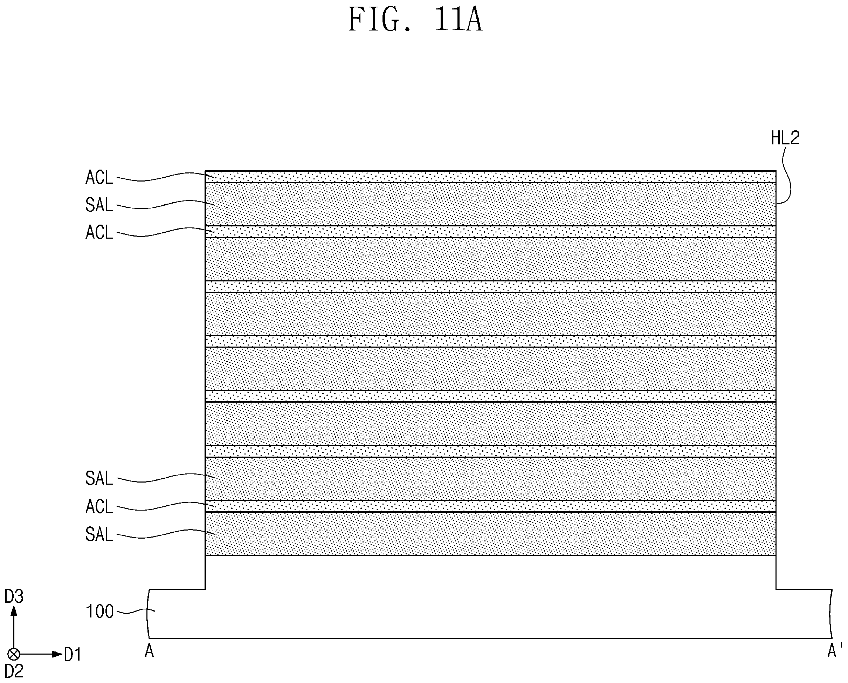

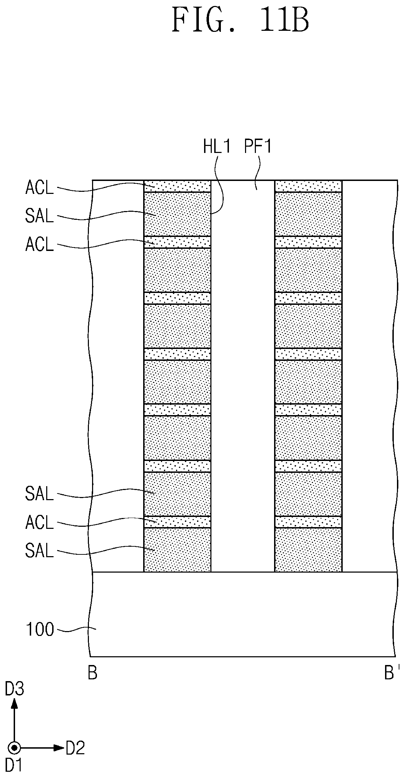

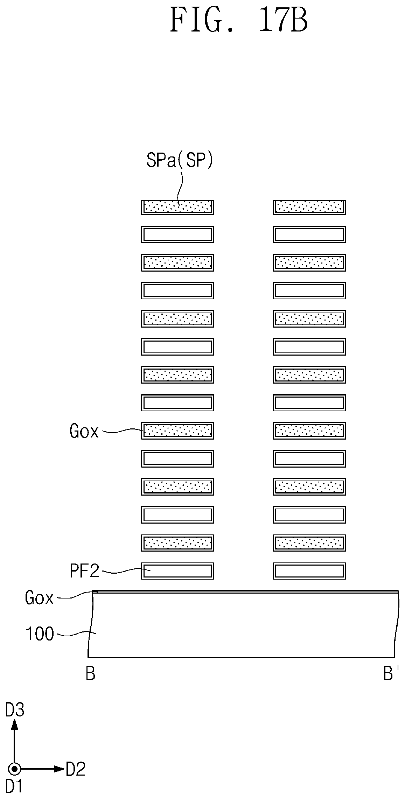

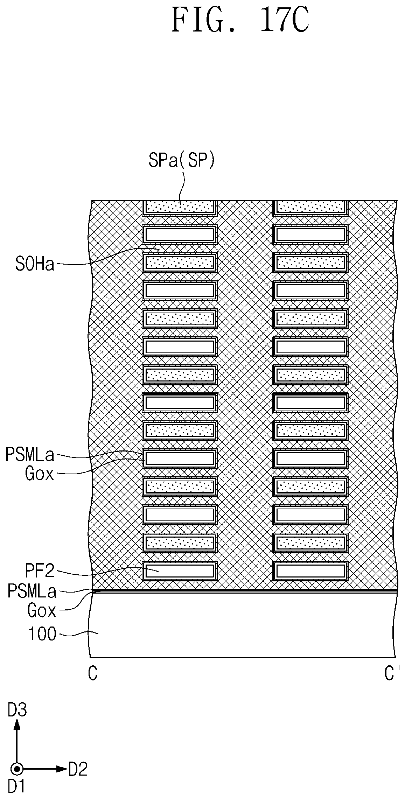

FIGS. 9, 10, 11A, 11B, 12, 13A, 13B, 14, 15, 16A,16B, 17A, 17B, 17C, 18, 19A, 19B, 19C, 20 - 22, 23A, 23B, 24, 25, 26A, 26B, 26C, and 27 - 29 are diagrams illustrating a method of fabricating a three-dimensional semiconductor device, according to an embodiment of the inventive concept. In detail, FIGS. 10, 12, 14, 18, and 21 are plan views illustrating a three-dimensional semiconductor device according to an embodiment of the inventive concept. FIGS. 11A, 13A, 15, 16A, 17A, 19A, 20, 22, 23A, 24A, 26A, 27, and 29 are sectional views, which are taken along a line A-A' of FIG. 3. FIGS. 11B, 13B, 16B, 17B, 19B, 23B, 24B, and 26B are sectional views, which are taken along a line B-B' of FIG. 3. FIGS. 17C, 19C, 24C, and 26C are sectional views, which are taken along a line C-C' of FIG. 3.

Referring to FIGS. 3 and 9, the substrate 100 may be prepared. Sacrificial layers SAL and active layers ACL may be formed to be alternatingly stacked on the substrate 100. Each of the sacrificial and active layers SAL and ACL may be formed of or include a semiconductor material. The sacrificial layers SAL may include a material having an etch selectivity with respect to the active layers ACL. Thus, removal of the active layers ACL may be reduced or minimized in a subsequent process of removing the sacrificial layers SAL. In an embodiment, the active and sacrificial layers ACL and SAL may be formed of or include at least one of silicon (Si), germanium (Ge), and/or silicon germanium (SiGe), but the material of the sacrificial layers SAL may be different from that of the active layers ACL. In an embodiment, the active layers ACL may be formed of or include silicon (Si), and the sacrificial layers SAL may be formed of or include silicon-germanium (SiGe). When measured in the third direction D3, a thickness of the sacrificial layers SAL may be larger than a thickness of the active layers ACL.

Referring to FIGS. 10 to 11B, first holes HL1 may be formed on the substrate 100 by partially removing each of the sacrificial and active layers SAL and ACL. The first holes HL1 may be formed to be adjacent to each other in the first and second directions D1 and D2. A portion of the top surface of the substrate 100 may be exposed to the outside through the first holes HL1. As a result of the removal process, the sacrificial and active layers SAL and ACL may be formed to include portions, which extend in the first direction D1, and portions, which extend in the second direction D2.

First preliminary filling patterns PF1 may be formed to be on and at least partially cover the exposed portion of the top surface of the substrate 100 and to at least partially fill the first holes HL1. In an embodiment, the first preliminary filling pattern PF1 may include an insulating material. The first preliminary filling patterns PF1 may be formed to be adjacent to each other in the first and second directions D1 and D2.

Some of the sacrificial and active layers SAL and ACL elongated in the second direction D2 may be removed to form second holes HL2 on the substrate 100. The second holes HL2 may be formed to extend in the second direction D2. Opposite side surfaces of the sacrificial and active layers SAL and ACL may be exposed to the outside through the second holes HL2. During the formation of the second holes HL2, an upper portion of the substrate 100 may be partially recessed to a specific depth. A portion of the top surface of the substrate 100 may be exposed to the outside through the second holes HL2.

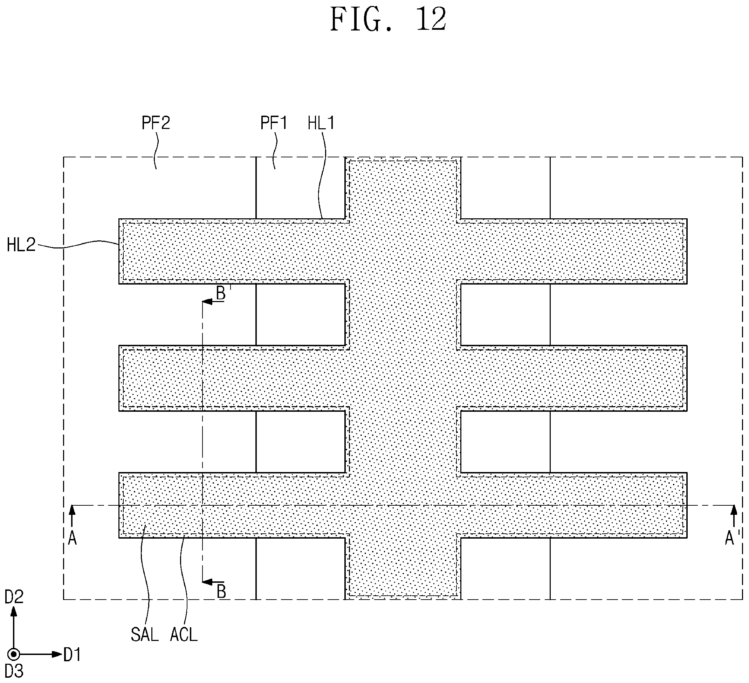

Referring to FIGS. 12 to 13B, the exposed opposite side surfaces of the sacrificial layers SAL may be selectively removed through the second holes HL2. Thus, first inner regions INR1 may be formed between the active layers ACL, which are adjacent to each other in the third direction D3. Each of the first preliminary filling patterns PF1 may also be partially removed during the removal process. Side surfaces of the first preliminary filling patterns PF1 may be aligned to side surfaces of the sacrificial layers SAL.

A second preliminary filling pattern PF2 may be formed in the first inner regions INRI. The second preliminary filling pattern PF2 may be formed to at least partially fill an empty region, which is formed by partially removing the first preliminary filling patterns PF1, and inner spaces of the second holes HL2. The second preliminary filling pattern PF2 may at least partially enclose and cover portions of the active layers ACL, which are not overlapped with the sacrificial layers SAL. The second preliminary filling pattern PF2 may include a single or composite layer including an insulating material. In an embodiment, the second preliminary filling pattern PF2 may be formed of or include at least one of silicon oxide and/or silicon nitride.

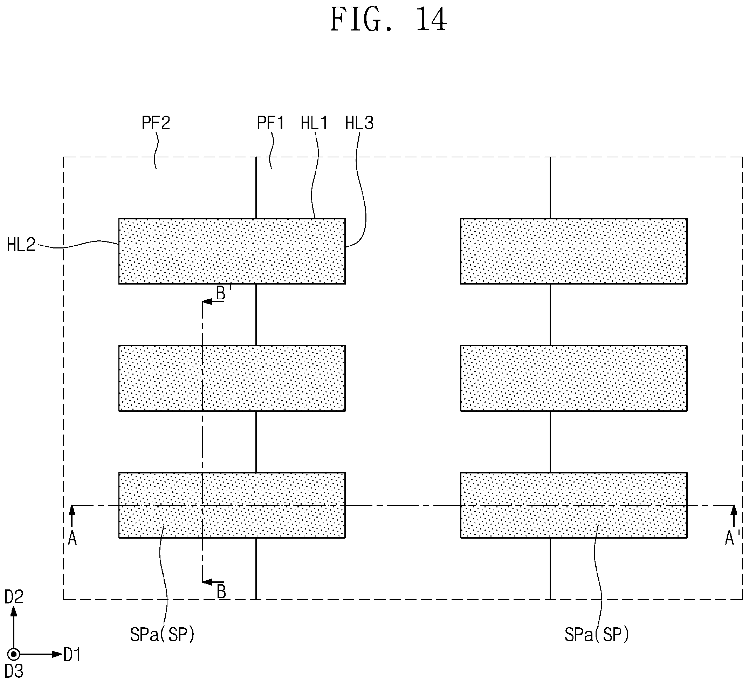

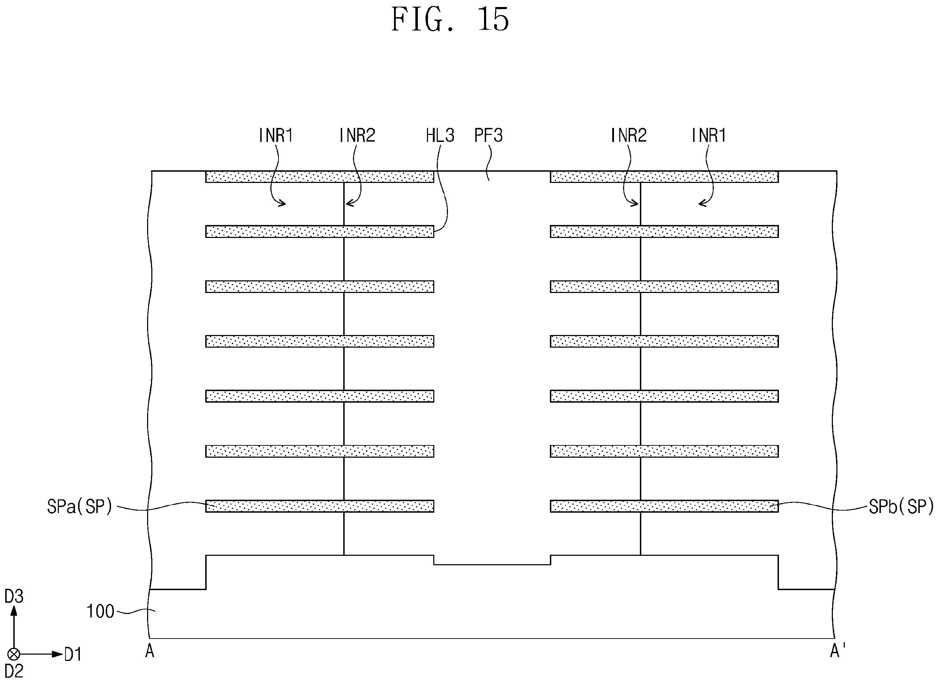

Referring to FIGS. 14 and 15, a third hole HL3 may be formed on the substrate 100 by removing the portion of the sacrificial and active layers SAL and ACL, which extend in the second direction D2. During the formation of the third holes HL3, each active layer ACL may be divided into the semiconductor patterns SP, which are adjacent to each other in the first direction D1. The semiconductor pattern SP may include the first and second semiconductor patterns SPa and SPb, which are adjacent to each other in the first direction D1. In the process of forming the third holes HL3, the sacrificial layers SAL may be at least partially exposed to the outside.

The exposed sacrificial layers SAL may be fully removed from the substrate 100 through the third holes HL3. Thus, second inner regions INR2 may be formed between regions of the active layers ACL, which are not overlapped with the second preliminary filling pattern PF2. During the removal process, the first preliminary filling patterns PF1 may be removed from a region on the substrate 100. Next, a third preliminary filling pattern PF3 may be formed to at least partially fill the second inner regions INR2, an empty region, which is formed by removing the first preliminary filling patterns PF1, and the third holes HL3. The third preliminary filling pattern PF3 may include a single or composite layer including an insulating material. In an embodiment, the third preliminary filling pattern PF3 may be formed of or include at least one of silicon oxide and/or silicon nitride.

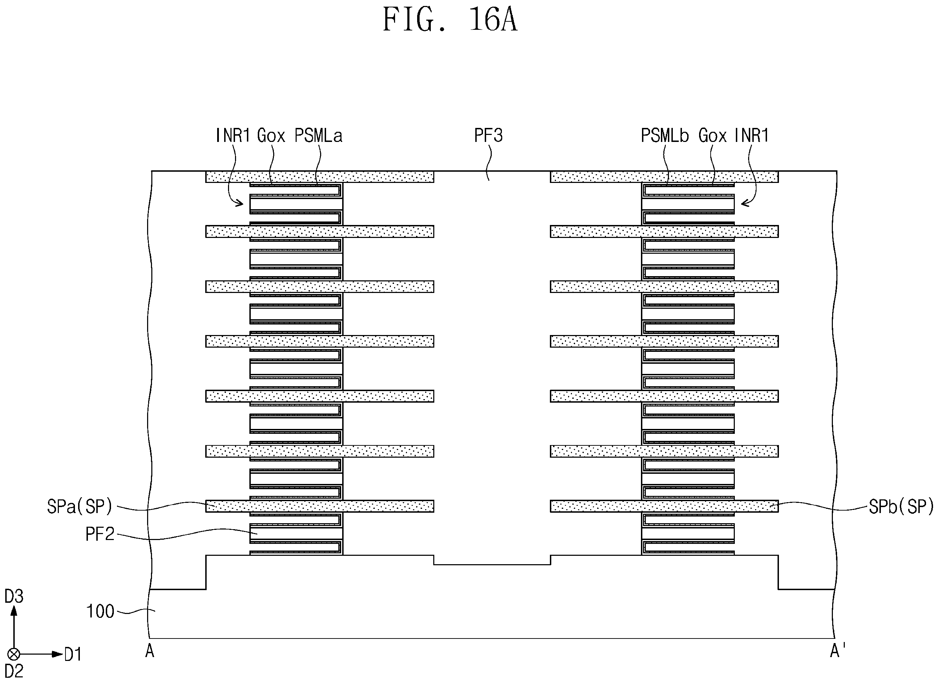

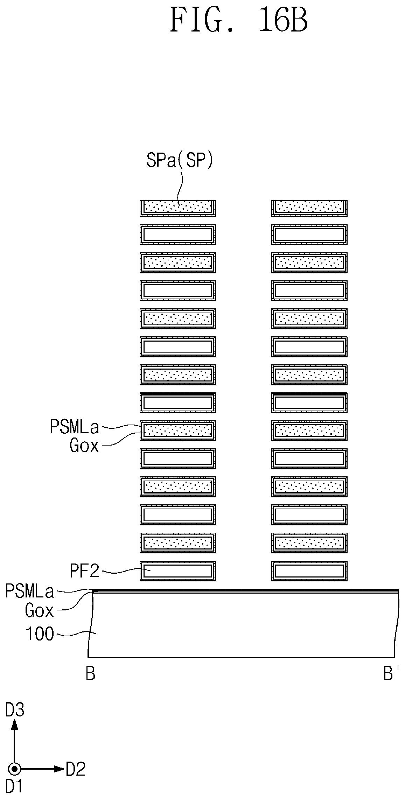

Referring to FIGS. 16A and 16B, the second preliminary filling pattern PF2 may be partially removed from the substrate 100. Next, the gate dielectric layer Gox and the preliminary metal liner layers PSMLa and PSMLb may be sequentially formed in an empty region, which is formed by removing the second preliminary filling pattern PF2. The gate dielectric layer Gox and the preliminary metal liner layers PSMLa and PSMLb may be sequentially formed to conformally cover a portion of the semiconductor pattern SP and a portion of the second preliminary filling pattern PF2. The gate dielectric layer Gox and the preliminary metal liner layers PSMLa and PSMLb may be formed to cover a portion of the semiconductor pattern SP and a portion of the second preliminary filling pattern PF2. The gate dielectric layer Gox and one of the preliminary metal liner layers PSMLa and PSMLb may be formed to enclose and cover a portion of each of the semiconductor patterns SP, which are adjacent to each other in the second and third directions D2 and D3.

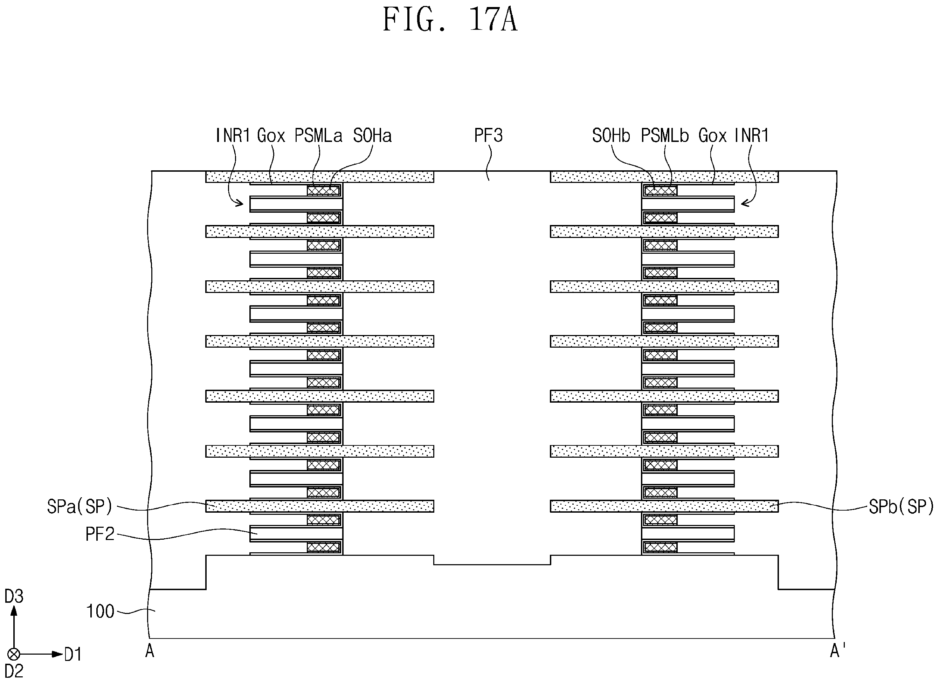

Referring to FIGS. 17A to 17C, hard mask layers SOHa and SOHb may be formed on the preliminary metal liner layers PSMLa and PSMLb. In detail, the hard mask layers SOHa and SOHb may be formed to partially fill a region between the preliminary metal liner layers PSMLa and PSMLb. The hard mask layers SOHa and SOHb may be inorganic hard mask layers or organic hard mask layers, and in an embodiment, may be a carbon-based hard mask layer (e.g., carbon-based SOH layer). The hard mask layers SOHa and SOHb may protect portions of the preliminary metal liner layers PSMLa and PSMLb in a subsequent etching process and may inhibit or prevent the portions of the preliminary metal liner layers PSMLa and PSMLb from being removed.

An etching process may be performed to remove exposed portions of the preliminary metal liner layers PSMLa and PSMLb, after the formation of the hard mask layers SOHa and SOHb. Other portions of the preliminary metal liner layers PSMLa and PSMLb, which are protected by the hard mask layers SOHa and SOHb and are not removed, may form the metal liner patterns SMLa and SMLb. In an embodiment, the preliminary metal liner layers PSMLa and PSMLb on the second preliminary filling pattern PF2 may also be removed by the etching process.

The metal liner patterns SMLa and SMLb may include the first metal liner pattern SMLa at least partially enclosing the first semiconductor patterns SPa and the second metal liner pattern SMLb at least partially enclosing the second semiconductor patterns SPb.

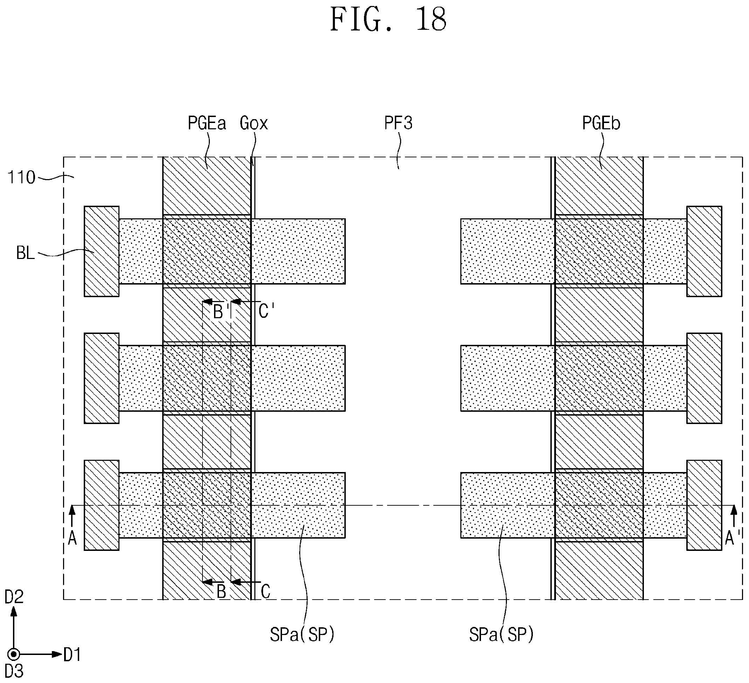

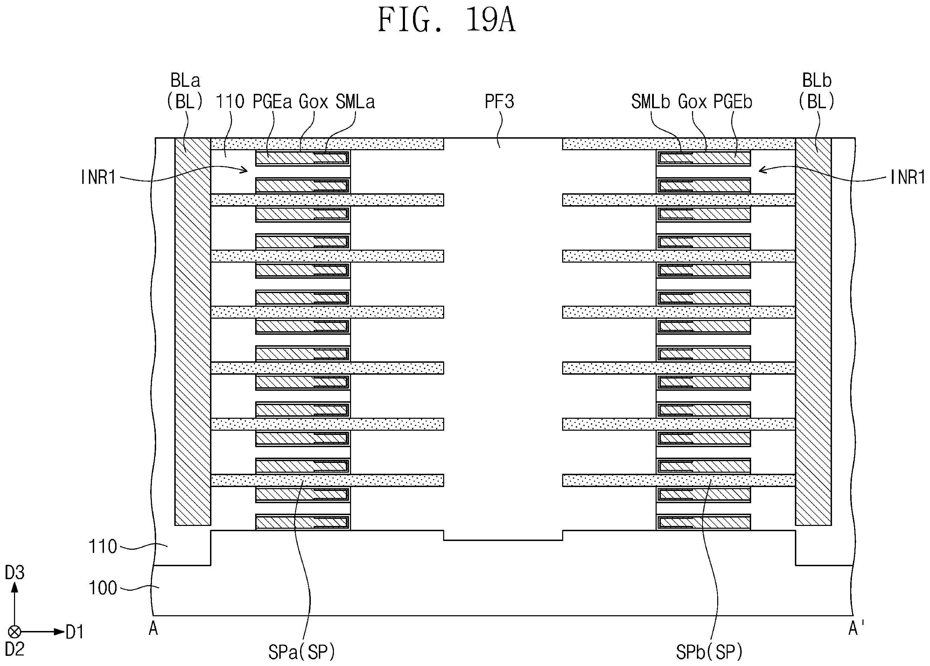

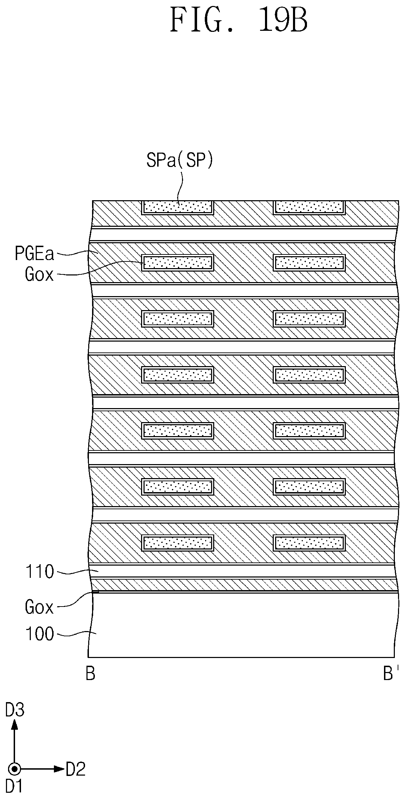

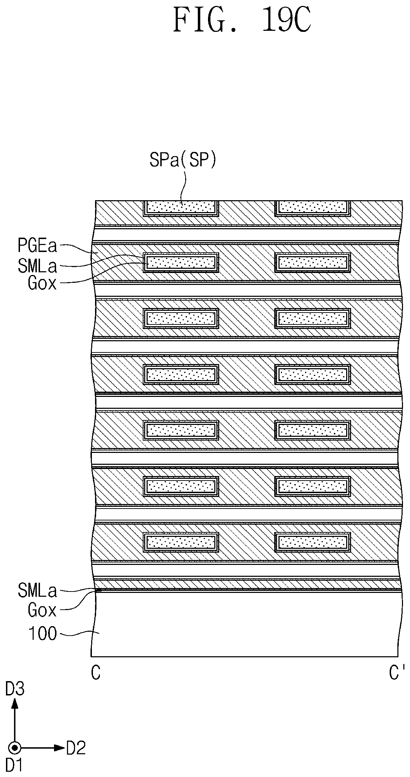

Referring to FIGS. 18 and 19A to 19C, the hard mask layers SOHa and SOHb on the metal liner patterns SMLa and SMLb may be removed by performing an ashing process or a strip process. After the removal of the hard mask layers SOHa and SOHb, preliminary gate electrode patterns PGEa and PGEb may be formed using the metal liner patterns SMLa and SMLb as a seed layer. In detail, the preliminary gate electrode patterns PGEa and PGEb may be formed by a selective growth method of selectively growing a layer from the seed layer in a specific direction (e.g., the first direction D1 or the opposite direction of the first direction D1).

In the case where the preliminary gate electrode patterns PGEa and PGEb are selectively grown in a specific direction, a metal material or a conductive material in the preliminary gate electrode patterns PGEa and PGEb may be formed to have a uniform grain size. Furthermore, because the preliminary gate electrode patterns PGEa and PGEb are grown in a specific direction, the preliminary gate electrode patterns PGEa and PGEb may be formed to have a uniform orientation. Thus, it may be possible to prevent or suppress a pattern failure (e.g., voids or seam) from occurring in the preliminary gate electrode patterns PGEa and PGEb and thereby to improve the reliability of the three-dimensional semiconductor device.

The preliminary gate electrode patterns PGEa and PGEb may include a first preliminary gate electrode pattern PGEa adjacent to the first semiconductor patterns SPa and a second preliminary gate electrode pattern PGEb adjacent to the second semiconductor patterns SPb.

The gate dielectric layer Gox and one of the preliminary gate electrode patterns PGEa and PGEb may be formed to at least partially enclose and cover a portion of each of the semiconductor patterns SP, which are adjacent to each other in the second and third directions D2 and D3. Next, the second preliminary filling pattern PF2 between the preliminary gate electrode patterns PGEa or PGEb may be removed, and the gapfill insulating pattern 110 may be formed in the first inner regions INR1 and an empty region, which is formed by removing the second preliminary filling pattern PF2.

The bit lines BL may be formed to penetrate or extend through the gapfill insulating pattern 110 and to be in contact with side surfaces of the semiconductor patterns SP. The bit lines BL may include the first bit lines BLa in contact with the first semiconductor patterns SPa and the second bit lines BLb in contact with the second semiconductor patterns SPb.

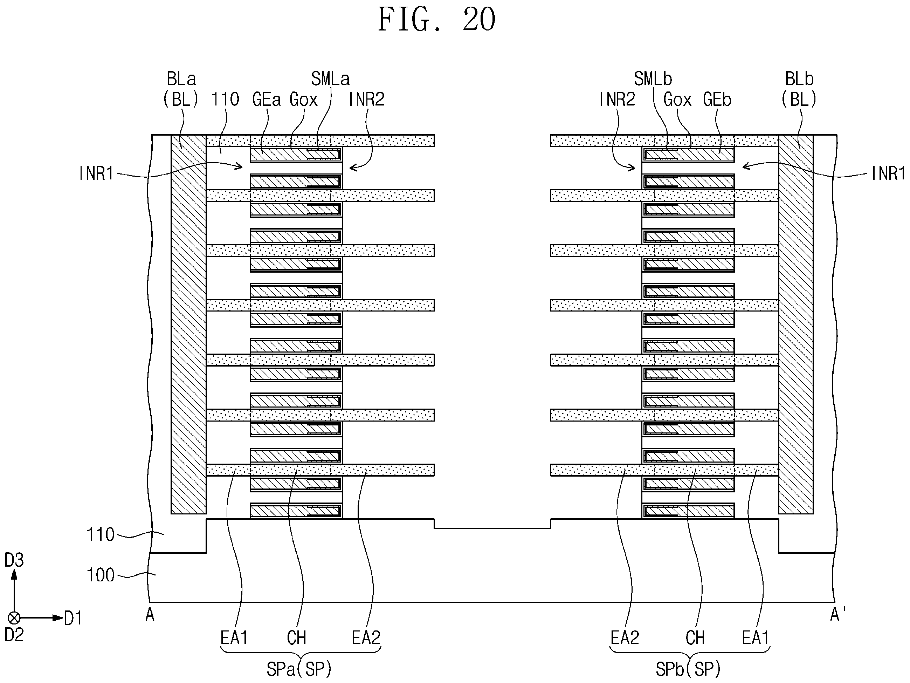

Referring to FIGS. 3 and 20, the third preliminary filling pattern PF3 may be removed from the substrate 100. A portion of the gate dielectric layer Gox may also be removed by the removal process. In this case, the metal liner patterns SMLa and SMLb and the preliminary gate electrode patterns PGEa and PGEb need not be removed, and thus, the metal liner patterns SMLa and SMLb may have a U-shaped structure. Thus, each of the gate dielectric layers Gox may be divided into a plurality of gate dielectric layers Gox, which are adjacent to each other in the second and third directions D2 and D3. Each of the gate dielectric layers Gox may be provided to at least partially enclose a corresponding one of the semiconductor patterns SP. After the removal of the third preliminary filling pattern PF3, the preliminary gate electrode patterns PGEa and PGEb may form the gate electrode patterns GEa and GEb. Each of the gate electrode patterns GEa and GEb may be provided to at least partially enclose a corresponding one of the semiconductor patterns SP.

During the removal process, the second inner regions INR2 may be exposed to the outside (external to the structure). A side surface of the gate dielectric layer Gox and a side surface of the gapfill insulating pattern 110 may be exposed to the outside (external to the structure) through the second inner regions INR2.

The gate electrode patterns GEa and GEb may include the first gate electrode patterns GEa at least partially enclosing the first semiconductor patterns SPa and the second gate electrode patterns GEb enclosing the second semiconductor patterns SPb.

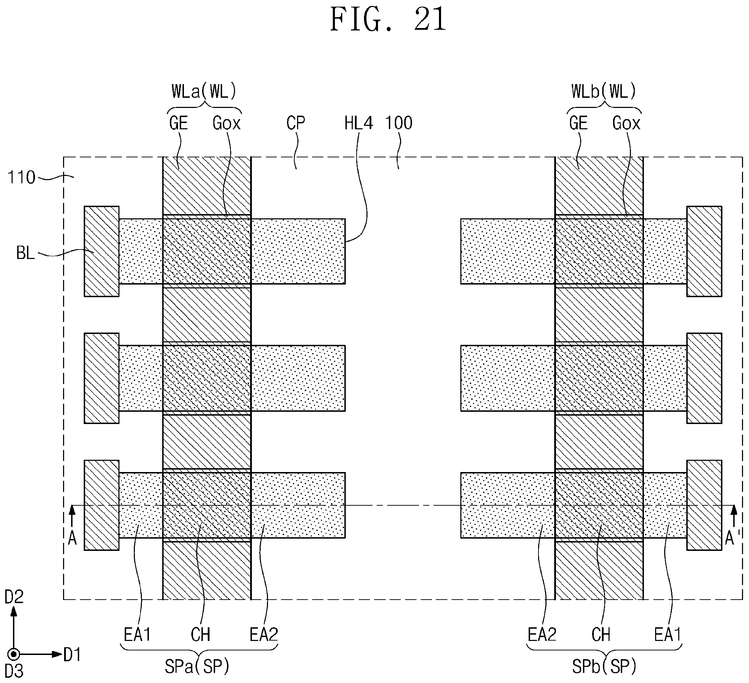

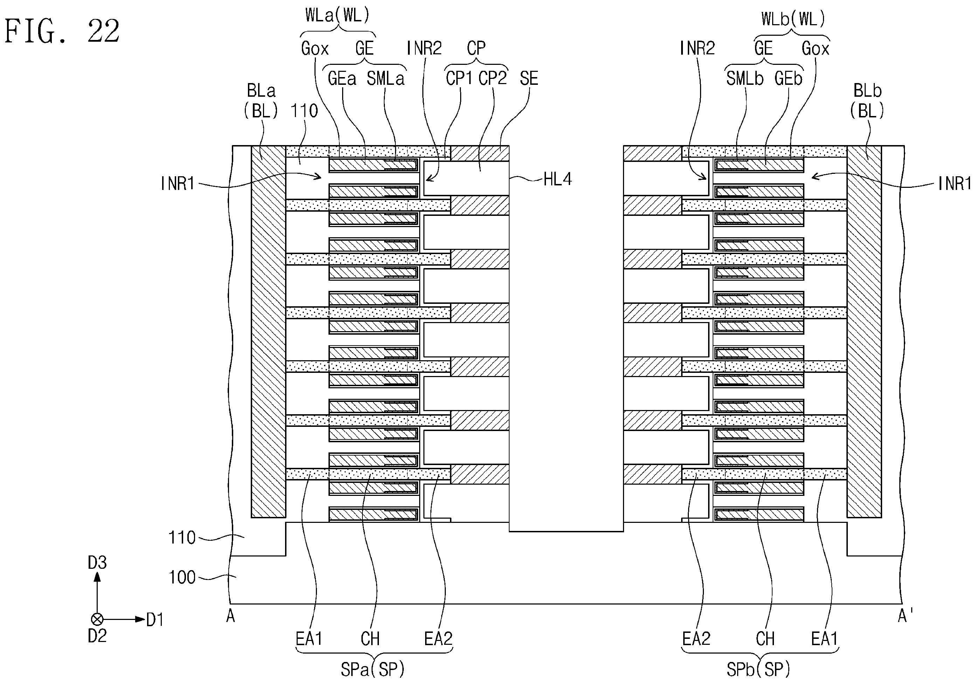

Referring to FIGS. 21 and 22, the capping pattern CP may be formed to at least partially fill the second inner regions INR2 and an empty region, which is formed by removing the third preliminary filling pattern PF3. The capping pattern CP may include the first capping pattern CP1, which is provided to conformally cover the second inner regions INR2 and the second edge portions EA2 of the semiconductor patterns SP, and the second capping pattern CP2, which is provided to at least partially fill remaining portions of the second inner regions INR2 and to enclose the second edge portions EA2 of the semiconductor patterns SP.

Next, a portion of the capping pattern CP may be removed to form a fourth hole HL4 on the substrate 100. The fourth hole HL4 may be formed to extend in the second direction D2. The second edge portions EA2 of the semiconductor patterns SP may be exposed to the outside (external to the structure) through the fourth hole HL4.

A removal process may be performed on the exposed second edge portions EA2 of the semiconductor patterns SP through the fourth hole HL4. Here, the removal process may also be performed on a portion of the first capping pattern CP1.

The storage electrodes SE may be formed on the second edge portions EA2 of the semiconductor patterns SP. In an embodiment, the formation of the storage electrodes SE may include forming silicide patterns (not shown) on the second edge portions EA2 of the semiconductor patterns SP and forming the storage electrodes SE through a SEG process using the silicide patterns as a seed layer.

Referring back to FIGS. 3 to 5C, a removal process may be performed on a portion of the second capping pattern CP2. In an embodiment, the side surface of the second capping pattern CP2 may be aligned to the side surface of the second edge portion EA2 of the semiconductor pattern SP. Thereafter, the capacitor dielectric layer CIL may be formed to conformally at least partially cover the storage electrodes SE. The plate electrode PE may be formed to at least partially fill a region between the storage electrodes SE and a remaining portion of the fourth hole HL4 described with reference to FIGS. 21 and 22. The storage electrode SE, the capacitor dielectric layer CIL, and the plate electrode PE may constitute the data storage pattern DSP. Thereafter, the protection layer PL may be formed to at least partially cover the cell array structure CS.

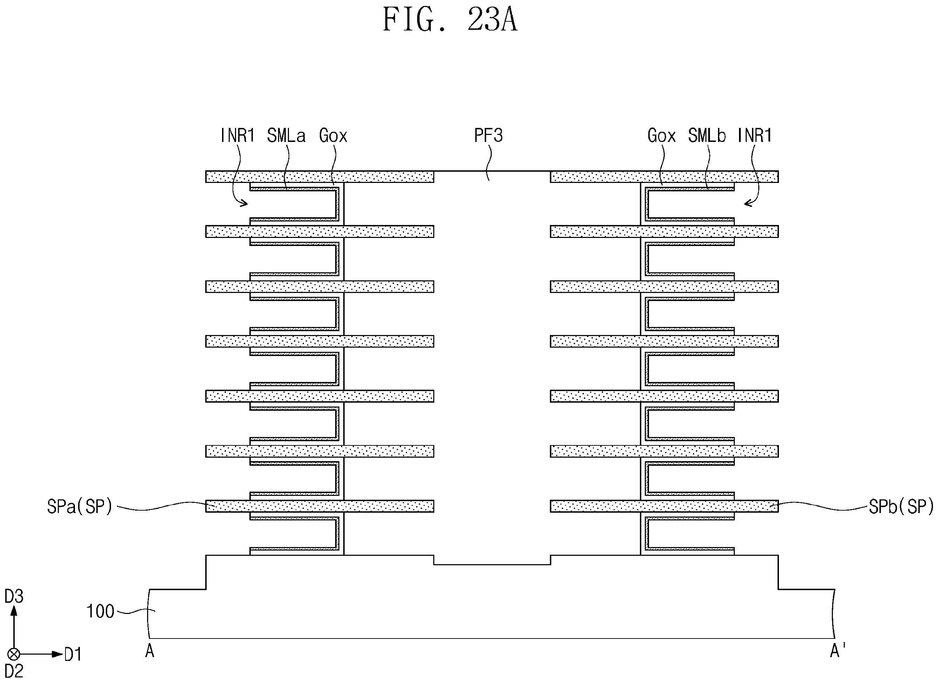

FIGS. 23A to 29 are diagrams illustrating a method of fabricating a three-dimensional semiconductor device, according to an embodiment of the inventive concept. FIGS. 23A to 29 illustrate a fabrication method different from that in the embodiment of FIGS. 16A to 22. In the following description, a previously-described element may be identified by the same reference number without repeating an overlapping description thereof, for concise description.

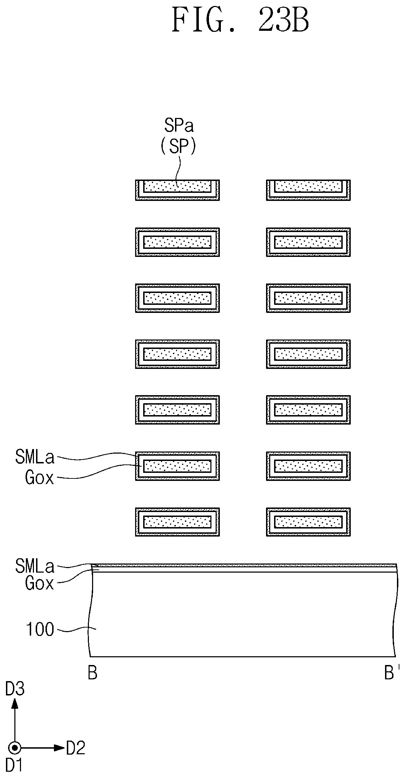

Referring to FIGS. 23A and 23B, the second preliminary filling pattern PF2 may be removed from the substrate 100. Next, the gate dielectric layer Gox and the metal liner patterns SMLa and SMLb may be sequentially formed in the first inner regions INR1. The gate dielectric layer Gox and the metal liner patterns SMLa and SMLb may be sequentially formed to conformally at least partially cover a portion of the semiconductor pattern SP. The gate dielectric layer Gox and the metal liner patterns SMLa and SMLb may be formed to enclose and cover a portion of the semiconductor pattern SP. Each of the gate dielectric layers Gox and each of the metal liner patterns SMLa and SMLb may be formed to enclose and cover a portion of each of the semiconductor patterns SP, which are adjacent to each other in the second and third directions D2 and D3. Thereafter, the gapfill insulating pattern 110 may be formed in the first inner regions INR1 and an empty region, which is formed by removing the second preliminary filling pattern PF2.

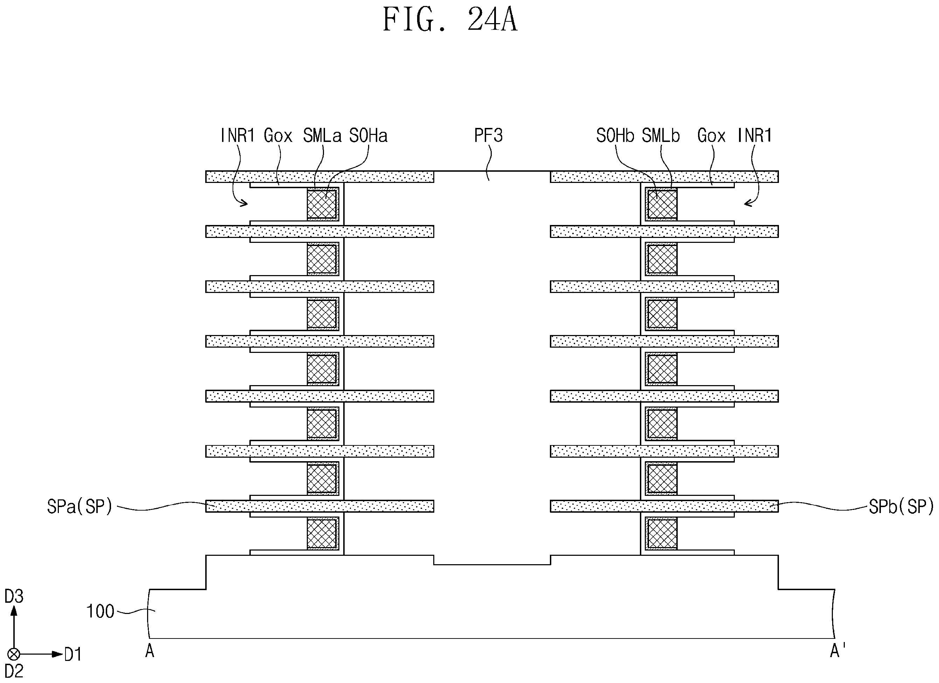

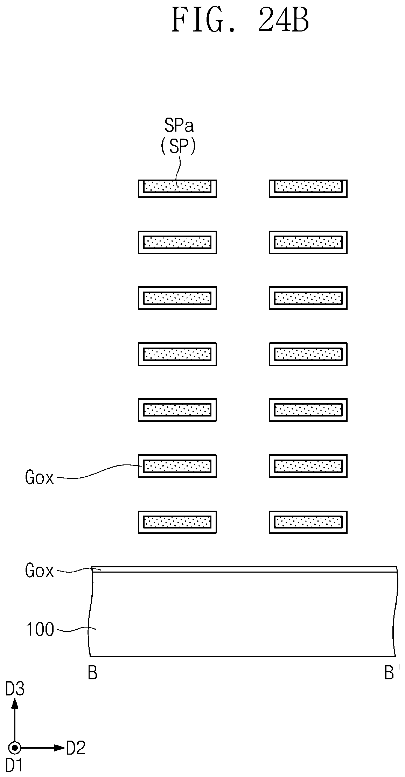

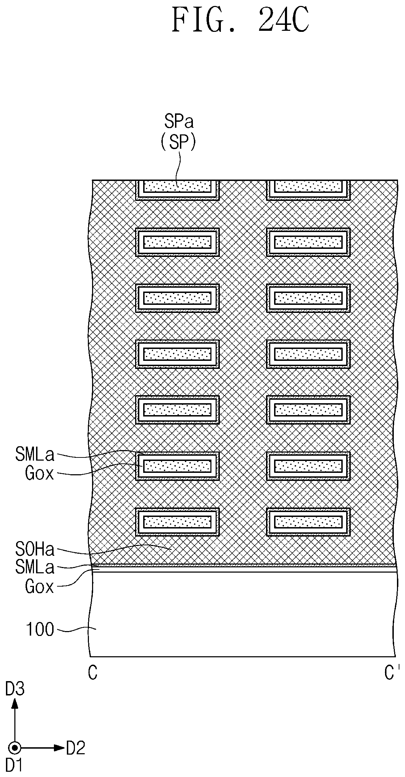

Referring to FIGS. 24A to 24C, the hard mask layers SOHa and SOHb may be formed on the metal liner patterns SMLa and SMLb. In detail, the hard mask layers SOHa and SOHb may be formed to partially fill a region between the metal liner patterns SMLa and SMLb. The hard mask layers SOHa and SOHb may be inorganic hard mask layers or organic hard mask layers, and in an embodiment, may be a carbon-based hard mask layer (e.g., carbon-based SOH layer). The hard mask layers SOHa and SOHb may protect portions of the metal liner patterns SMLa and SMLb in a subsequent etching process and may inhibit or prevent the portions of the metal liner patterns SMLa and SMLb from being removed.

After the formation of the hard mask layers SOHa and SOHb, an etching process may be performed to remove exposed portions of the metal liner patterns SMLa and SMLb. Other portions of the metal liner patterns SMLa and SMLb, which are protected by the hard mask layers SOHa and SOHb and are not removed, may form the metal liner patterns SMLa and SMLb.

The metal liner patterns SMLa and SMLb may include the first metal liner pattern SMLa at least partially enclosing the first semiconductor patterns SPa and the second metal liner pattern SMLb at least partially enclosing the second semiconductor patterns SPb.

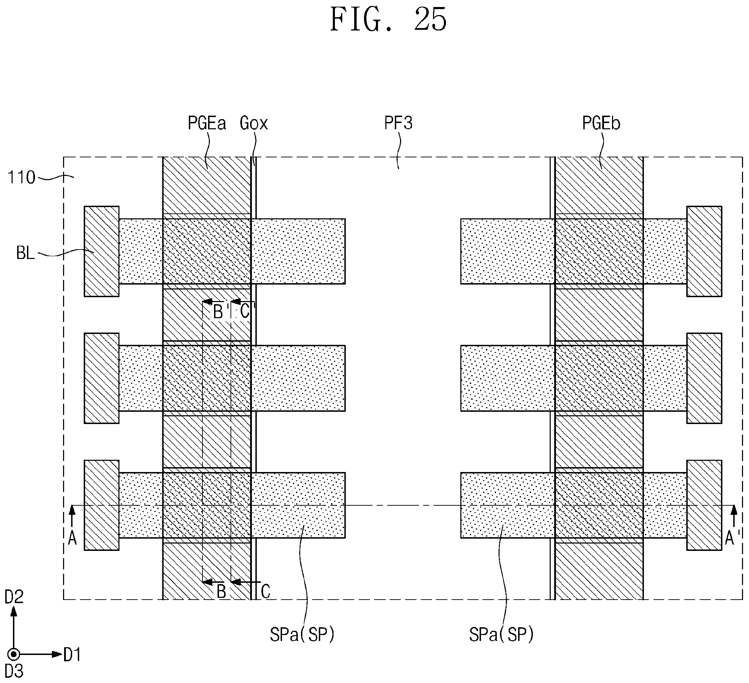

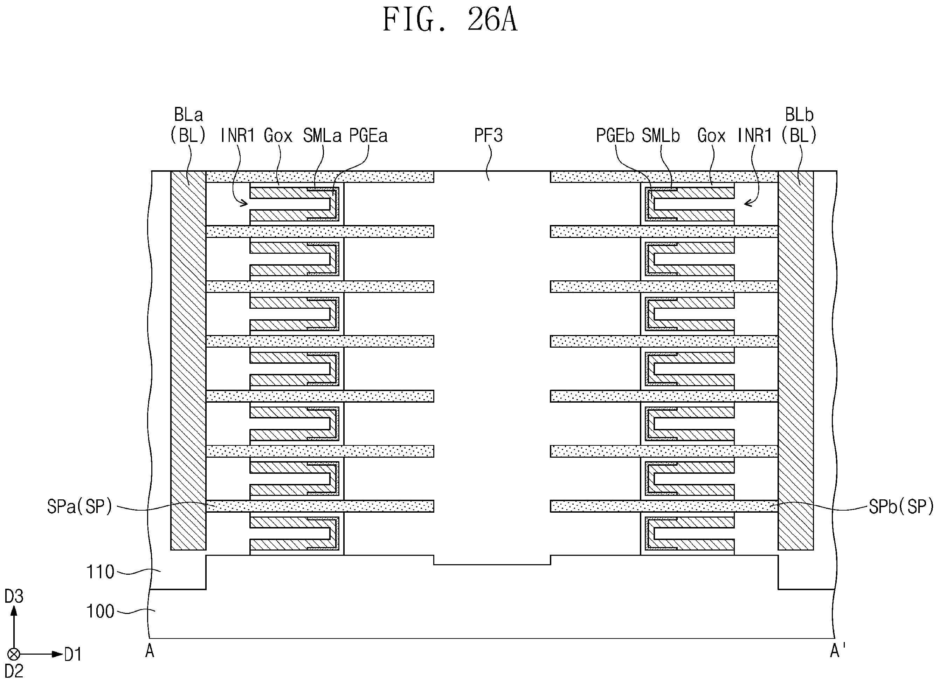

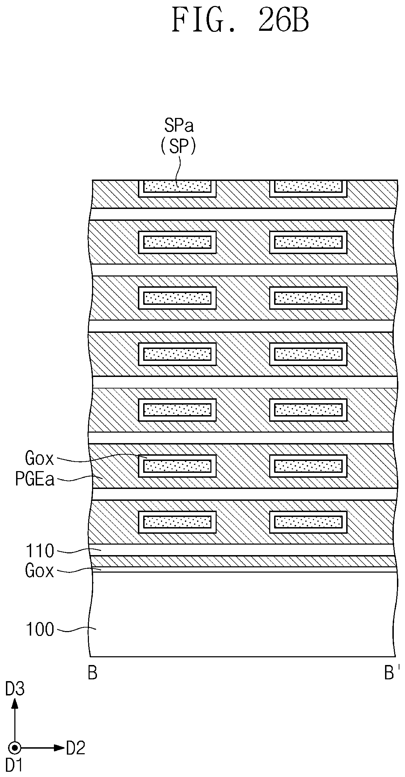

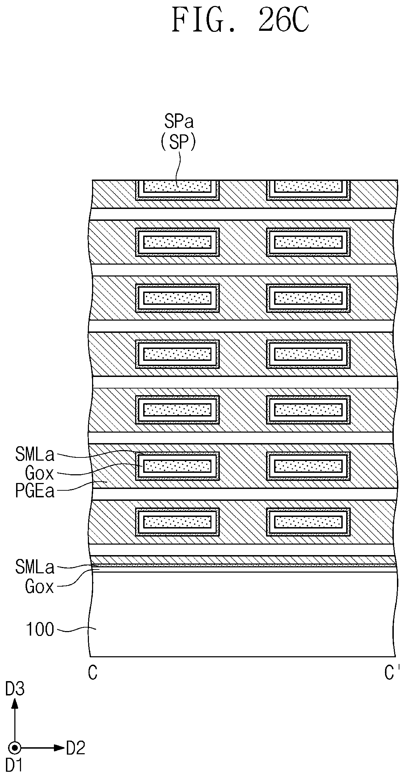

Referring to FIGS. 25 and 26A to 26C, the hard mask layers SOHa and SOHb on the metal liner patterns SMLa and SMLb may be removed by performing an ashing process or a strip process. After the removal of the hard mask layers SOHa and SOHb, the preliminary gate electrode patterns PGEa and PGEb may be formed using the metal liner patterns SMLa and SMLb as a seed layer. In detail, the preliminary gate electrode patterns PGEa and PGEb may be formed by a selective growth method of selectively growing a layer from the seed layer in a specific direction (e.g., the first direction D1 or the opposite direction of the first direction D1). The metal liner patterns SMLa and SMLb may have a U-shaped structure.

In the case where the preliminary gate electrode patterns PGEa and PGEb are selectively grown in a specific direction, a metal material or a conductive material in the preliminary gate electrode patterns PGEa and PGEb may be formed to have a uniform grain size. Furthermore, because the preliminary gate electrode patterns PGEa and PGEb are grown in a specific direction, the preliminary gate electrode patterns PGEa and PGEb may be formed to have a uniform orientation. Thus, it may be possible to prevent or suppress a pattern failure (e.g., voids or seam) from occurring in the preliminary gate electrode patterns PGEa and PGEb and thereby to improve the reliability of the three-dimensional semiconductor device.

The preliminary gate electrode patterns PGEa and PGEb may include the first preliminary gate electrode pattern PGEa adjacent to the first semiconductor patterns SPa and the second preliminary gate electrode pattern PGEb adjacent to the second semiconductor patterns SPb.

Each of the gate dielectric layers Gox and each of the preliminary gate electrode patterns PGEa and PGEb may be formed to enclose and cover a portion of each of the semiconductor patterns SP, which are adjacent to each other in the second and third directions D2 and D3. Thereafter, the gapfill insulating pattern 110 may be formed in the first inner regions INR1 and an empty region, which is formed by removing the second preliminary filling pattern PF2.

The bit lines BL may be formed to penetrate or extend through the gapfill insulating pattern 110 and to be in contact with side surfaces of the semiconductor patterns SP. The bit lines BL may include the first bit lines BLa in contact with the first semiconductor patterns SPa and the second bit lines BLb in contact with the second semiconductor patterns SPb.

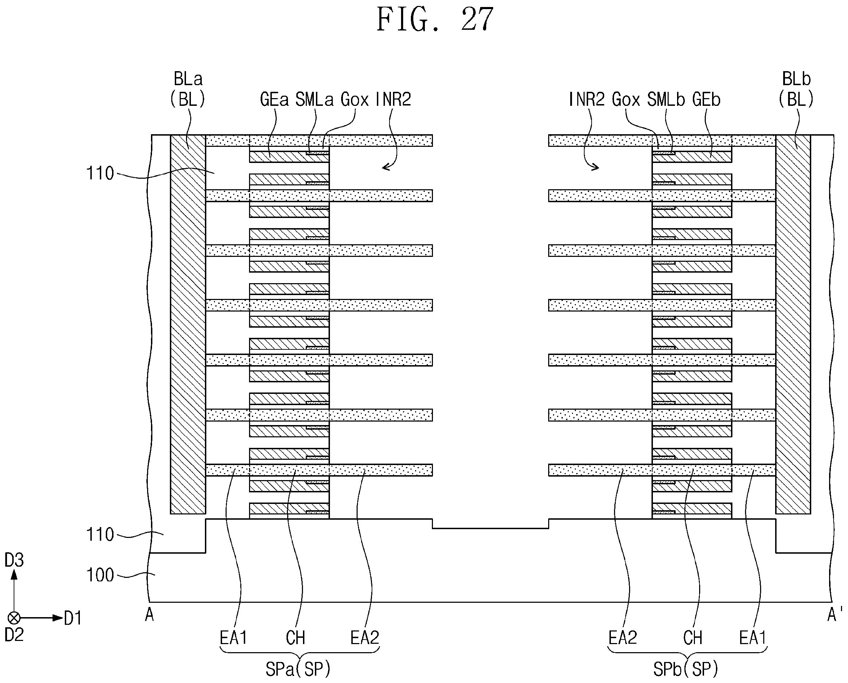

Referring to FIGS. 3 and 27, the third preliminary filling pattern PF3 may be removed from the substrate 100. The gate dielectric layer Gox and the preliminary gate electrode patterns PGEa and PGEb may also be removed by the removal process. Thus, each of the gate dielectric layers Gox may be divided into a plurality of gate dielectric layers Gox, which are adjacent to each other in the second and third directions D2 and D3. In addition, each of the preliminary gate electrode patterns PGEa and PGEb may be divided into a plurality of preliminary gate electrode patterns PGEa and PGEb, which are adjacent to each other in the second and third directions D2 and D3. Furthermore, a side surface of the metal liner patterns SMLa and SMLb having the U-shaped structure may also be removed, and thus, the metal liner patterns SMLa and SMLb may be divided into the metal liner patterns SMLa and SMLb, which are adjacent to each other in the second and third directions D2 and D3.

Each of the gate dielectric layers Gox may at least partially enclose a corresponding one of the semiconductor patterns SP. After the partial removal of the third preliminary filling pattern PF3, the gate dielectric layer Gox, and the preliminary gate electrode patterns PGEa and PGEb, the preliminary gate electrode patterns PGEa and PGEb may form the gate electrode patterns GEa and GEb. Each of the gate electrode patterns GEa and GEb may be provided to at least partially enclose a corresponding one of the semiconductor patterns SP.

During the removal process, the second inner regions INR2 may be exposed to the outside (external to the structure). Side surfaces of the gate electrode patterns GEa and GEb and side surfaces of the metal liner patterns SMLa and SMLb may be exposed to the outside (external to the structure) through the second inner regions INR2.

After the removal process, the first metal liner patterns SMLa may be provided on the top surface of the first gate electrode pattern GEa or the bottom surface of the first gate electrode pattern GEa. That is, the first metal liner pattern SMLa may have a bar-shaped structure extending in the first direction D1, not a U-shaped structure. The second metal liner patterns SMLb may be provided on a top or bottom surface of a second gate electrode pattern GEb. That is, the second metal liner pattern SMLb may have a bar-shaped structure extending in the first direction D1, not a U-shaped structure.

Each of the first and second metal liner patterns SMLa and SMLb may be formed on a portion of the top or bottom surface of the gate dielectric layer Gox, with the channel region CH interposed therebetween.

The gate electrode patterns GEa and GEb may include the first gate electrode patterns GEa at least partially enclosing the first semiconductor patterns SPa and the second gate electrode patterns GEb at least partially enclosing the second semiconductor patterns SPb.

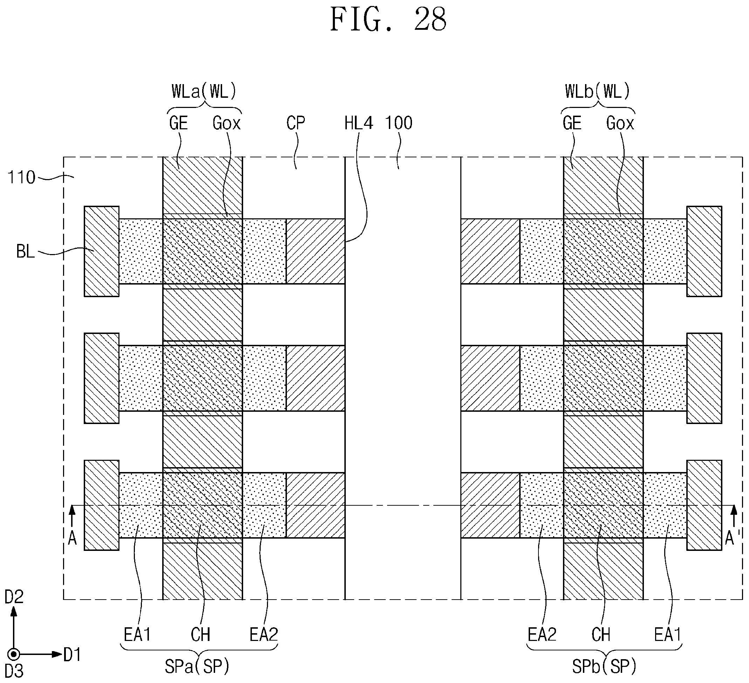

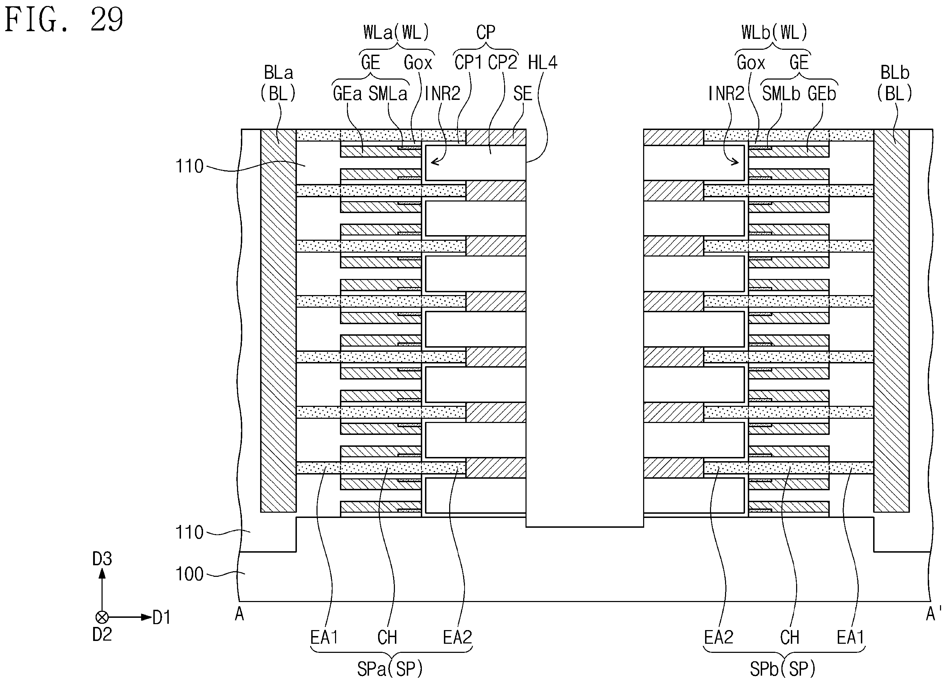

Referring to FIGS. 28 and 29, the capping pattern CP may be formed to at least partially fill the second inner regions INR2 and an empty region, which is formed by removing the third preliminary filling pattern PF3. The capping pattern CP may include the first capping pattern CP1, which is provided to conformally at least partially cover the second inner regions INR2 and the second edge portions EA2 of the semiconductor patterns SP, and the second capping pattern CP2, which is provided to at least partially fill remaining portions of the second inner regions INR2 and to at least partially enclose the second edge portions EA2 of the semiconductor patterns SP.

Next, a portion of the capping pattern CP may be removed to form the fourth hole HL4 on the substrate 100. The fourth hole HL4 may be formed to extend in the second direction D2. The second edge portions EA2 of the semiconductor patterns SP may be at least partially exposed to the outside (external to the structure) through the fourth hole HL4.

A removal process may be performed on the exposed second edge portions EA2 of the semiconductor patterns SP through the fourth hole HL4. Here, the removal process may also be performed on a portion of the first capping pattern CP1.

The storage electrodes SE may be formed on the second edge portions EA2 of the semiconductor patterns SP. In an embodiment, the formation of the storage electrodes SE may include forming silicide patterns (not shown) on the second edge portions EA2 of the semiconductor patterns SP and forming the storage electrodes SE through a SEG process using the silicide patterns as a seed layer.

Referring back to FIGS. 3 and 7A to 7C, a removal process may be performed on a portion of the second capping pattern CP2. In an embodiment, the side surface of the second capping pattern CP2 may be aligned to the side surface of the second edge portion EA2 of the semiconductor pattern SP. Thereafter, the capacitor dielectric layer CIL may be formed to conformally at least partially cover the storage electrodes SE. The plate electrode PE may be formed to at least partially fill a region between the storage electrodes SE and a remaining portion of the fourth hole HL4 described with reference to FIGS. 21 and 22. The storage electrode SE, the capacitor dielectric layer CIL, and the plate electrode PE may constitute the data storage pattern DSP. Thereafter, the protection layer PL may be formed to at least partially cover the cell array structure CS.

According to an embodiment of the inventive concept, a word line may include a metal liner pattern and a gate electrode on the metal liner pattern, and the gate electrode may be formed from the metal liner pattern by a selective growth process. Thus, the gate electrode may have a uniform grain size and a uniform orientation, and this may make it possible to reduce a pattern failure (e.g., voids or seam) in the word line. As a result, the resistance of the word line may be reduced.

In addition, it may be possible to reduce a gate-induced leakage current (GIDL) phenomenon in the semiconductor pattern, when a three-dimensional semiconductor device is operated. As a result, an amount of holes accumulated in the semiconductor pattern may be reduced, and a leakage current caused by the holes may be reduced.

Thus, the reliability of the three-dimensional semiconductor device may be improved.

While example embodiments of the inventive concept have been particularly shown and described, it will be understood by one of ordinary skill in the art that variations in form and detail may be made therein without departing from the scope of the attached claims.
Embodiments are set out in the following clauses:
Clause 1. A three-dimensional semiconductor device, comprising:
   a semiconductor pattern spaced apart from a substrate that extends in a first direction parallel to a bottom surface of the substrate;
   a word line that at least partially encloses the semiconductor pattern and extends in a second direction, which is parallel to the bottom surface of the substrate and is orthogonal to the first direction; and
   a bit line on a first side surface of the semiconductor pattern that extends in a third direction perpendicular to the bottom surface of the substrate,
   wherein the word line comprises a gate dielectric layer that at least partially encloses the semiconductor pattern and a gate electrode on the gate dielectric layer,
   wherein the gate electrode comprises a metal liner pattern and a gate electrode pattern on a side surface of the metal liner pattern, and
   wherein the metal liner pattern has a U-shaped structure.
Clause 2. The three-dimensional semiconductor device of clause 1, further comprising a capping pattern at a side of the word line,
   wherein the metal liner pattern extends from a top surface of the gate dielectric layer to a bottom surface of the gate dielectric layer via a side surface of the capping pattern.
Clause 3. The three-dimensional semiconductor device of clause 1 or 2, wherein the metal liner pattern is a liner pattern, which is conformally formed on the gate dielectric layer.
Clause 4. The three-dimensional semiconductor device of clause 1, 2 or 3, wherein the metal liner pattern has a thickness ranging from 1 Å to 50 Å.
Clause 5. The three-dimensional semiconductor device of any one of clauses 1 to 4, wherein the gate electrode pattern comprises a first portion at least partially enclosed by the metal liner pattern and a second portion at least partially enclosed by the gate dielectric layer.
Clause 6. The three-dimensional semiconductor device of clause 5, wherein a height of the second portion is greater than a height of the first portion in the third direction.
Clause 7. The three-dimensional semiconductor device of clause 5 or 6, wherein top and bottom surfaces of the second portion are free of the metal liner.
Clause 8. The three-dimensional semiconductor device of any one of clauses 1 to 7, wherein a work function of the metal liner pattern is less than a work function of the gate electrode pattern.
Clause 9. The three-dimensional semiconductor device of any one of clauses 1 to 8, wherein the metal liner pattern comprises at least one of Li, Na, K, Cs, Rb, Sr, Ba, Ca, Ce, Sm, Eu, Mg, Sc, Y, Hf, Tl, As, La, Nd, Gd, Tb, Lu, Th, U, Mn, Al, Ga, In, Pb, Cd, Bi, Zr, Ti, TiN, or n-type doped poly Si.
Clause 10. The three-dimensional semiconductor device of any one of clause 1 to 9, wherein the gate electrode pattern comprises at least one of Ti, TiN, TiSiN, TiON, W, WN, Mo, Ru, MoN, MoOₓN_{y}, Ta, TaN, or poly Si.
Clause 11. The three-dimensional semiconductor device of any one of clause 1 to 10, wherein the semiconductor pattern comprises at least one of single crystalline semiconductor materials, polycrystalline semiconductor materials, oxide semiconductor materials, or two-dimensional materials.
Clause 12. The three-dimensional semiconductor device of any one of clauses 1 to 11, further comprising a data storage pattern, which is on a second side surface of the semiconductor pattern opposite to the first side surface.
Clause 13. A three-dimensional semiconductor device, comprising:
   a semiconductor pattern spaced apart from a substrate that extends in a first direction parallel to a bottom surface of the substrate;
   a word line that at least partially encloses the semiconductor pattern and extends in a second direction, which is parallel to the bottom surface of the substrate and is orthogonal to the first direction; and
   a bit line that extends in a third direction perpendicular to the bottom surface of the substrate, on a first side surface of the semiconductor pattern,
   wherein the word line comprises a gate dielectric layer that at least partially encloses the semiconductor pattern and a gate electrode on the gate dielectric layer,
   wherein the gate electrode comprises a metal liner pattern and a gate electrode pattern on a side surface of the metal liner pattern,
   wherein the gate electrode pattern comprises a material having a higher work function than the metal liner pattern, and
   wherein the gate electrode pattern has a uniform grain size.
Clause 14. The three-dimensional semiconductor device of clause 13, wherein the material in the gate electrode pattern has a uniform and continuous orientation.
Clause 15. The three-dimensional semiconductor device of clause 13 or 14, wherein the material in the gate electrode pattern comprises at least one of Ti, TiN, TiSiN, TiON, W, WN, Mo, Ru, MoN, MoOₓN_{y}, Ta, TaN, or poly Si.
Clause 16. The three-dimensional semiconductor device of clause 13, 14 or 15, wherein a material in the metal liner pattern comprises at least one of Li, Na, K, Cs, Rb, Sr, Ba, Ca, Ce, Sm, Eu, Mg, Sc, Y, Hf, Tl, As, La, Nd, Gd, Tb, Lu, Th, U, Mn, Al, Ga, In, Pb, Cd, Bi, Zr, Ti, TiN, or n-type doped poly Si.
Clause 17. The three-dimensional semiconductor device of any one of clauses 13 to 16, further comprising a data storage pattern on a second side surface opposite to the first side surface of the semiconductor pattern.
Clause 18. A three-dimensional semiconductor device, comprising:
   a first stack and a second stack, which are on a substrate and are adjacent to each other in a first direction parallel to a bottom surface of the substrate; and
   a data storage pattern between the first stack and the second stack,
   wherein the first stack comprises:
      a first semiconductor pattern spaced apart from the substrate that extends in the first direction;
      a first word line that at least partially encloses the first semiconductor pattern and extends in a second direction, which is parallel to the bottom surface of the substrate and is orthogonal to the first direction;
      a first bit line on a first side surface of the first semiconductor pattern and extends in a third direction perpendicular to the bottom surface of the substrate; and
      a capping pattern at a side of the first word line,
   wherein the first word line comprises a gate dielectric layer that at least partially encloses the first semiconductor pattern and a first gate electrode on the gate dielectric layer,
   wherein the first gate electrode comprises a first metal liner pattern, which has a first work function, and a first gate electrode pattern, which is on a side surface of the first metal liner pattern and has a second work function,
   wherein the first metal liner pattern extends from a top surface of the gate dielectric layer to a bottom surface of the gate dielectric layer via a side surface of the capping pattern, and
   wherein the second work function is greater than the first work function.
Clause 19. The three-dimensional semiconductor device of clause 18, wherein the second stack comprises:
   a second semiconductor pattern spaced apart from the substrate and extends in the first direction;
   a second word line that at least partially encloses the second semiconductor pattern and extends in the second direction; and
   a second bit line on a side surface of the second semiconductor pattern and extends in the third direction.
Clause 20. The three-dimensional semiconductor device of clause 18 or 19, wherein the first metal liner pattern comprises at least one of Li, Na, K, Cs, Rb, Sr, Ba, Ca, Ce, Sm, Eu, Mg, Sc, Y, Hf, Tl, As, La, Nd, Gd, Tb, Lu, Th, U, Mn, Al, Ga, In, Pb, Cd, Bi, Zr, Ti, TiN, or n-type doped poly Si, and wherein the first gate electrode pattern comprises at least one of Ti, TiN, TiSiN, TiON, W, WN, Mo, Ru, MoN, MoOₓN_{y}, Ta, TaN, or poly Si.

## Claims

1. A three-dimensional semiconductor device, comprising:
a semiconductor pattern (SP) spaced apart from a substrate (100) that extends in a first direction (D1) parallel to a bottom surface of the substrate (100);
a word line (WL) that at least partially encloses the semiconductor pattern (SP) and extends in a second direction (D2), which is parallel to the bottom surface of the substrate (100) and is orthogonal to the first direction (D1); and
a bit line (BL) on a first side surface (S1) of the semiconductor pattern (SP) that extends in a third direction (D3) perpendicular to the bottom surface of the substrate (100),
wherein the word line (WL) comprises a gate dielectric layer (Gox) that at least partially encloses the semiconductor pattern (SP) and a gate electrode (GE) on the gate dielectric layer (Gox),
wherein the gate electrode (GE) comprises a metal liner pattern (SML) and a gate electrode pattern (GEP) on a side surface of the metal liner pattern (SML), and
wherein the gate electrode pattern (GEP) comprises a material having a higher work function than the metal liner pattern (SML), and
wherein the gate electrode pattern (GEP) has a uniform grain size and/ or the gate electrode pattern (GEP) is a result of a selective growth process..

2. The three-dimensional semiconductor device of claim 1, further comprising a capping pattern (CP) at a side of the word line (WL),
wherein the metal liner pattern (SML) extends from a top surface of the gate dielectric layer (Gox) to a bottom surface of the gate dielectric layer (Gox) via a side surface of the capping pattern (CP).

3. The three-dimensional semiconductor device of claim 1 or 2, wherein the metal liner pattern (SML) is a liner pattern, which is conformally formed on the gate dielectric layer (Gox).

4. The three-dimensional semiconductor device of claim 1, 2 or 3, wherein the metal liner pattern (SML) has a thickness ranging from 1 Å to 50 Å.

5. The three-dimensional semiconductor device of any one of claims 1 to 4, wherein the gate electrode pattern (GEP) comprises a first portion at least partially enclosed by the metal liner pattern (SML) and a second portion at least partially enclosed by the gate dielectric layer (Gox).

6. The three-dimensional semiconductor device of claim 5, wherein a height of the second portion is greater than a height of the first portion in the third direction (D3).

7. The three-dimensional semiconductor device of claim 5 or 6, wherein top and bottom surfaces of the second portion are free of the metal liner.

8. The three-dimensional semiconductor device of any one of claims 1 to 7, wherein the gate electrode pattern is a selectively grown pattern that has been grown in a single direction using the metal liner as a seed.

9. The three-dimensional semiconductor device of any one of claims 1 to 8, wherein the metal liner pattern (SML) comprises at least one of Li, Na, K, Cs, Rb, Sr, Ba, Ca, Ce, Sm, Eu, Mg, Sc, Y, Hf, Tl, As, La, Nd, Gd, Tb, Lu, Th, U, Mn, Al, Ga, In, Pb, Cd, Bi, Zr, Ti, TiN, or n-type doped poly Si.

10. The three-dimensional semiconductor device of any one of claims 1 to 9, wherein the gate electrode pattern (GEP) comprises at least one of Ti, TiN, TiSiN, TiON, W, WN, Mo, Ru, MoN, MoOₓN_{y}, Ta, TaN, or poly Si.

11. The three-dimensional semiconductor device of any one of claims 1 to 10, wherein the semiconductor pattern (SP) comprises at least one of single crystalline semiconductor materials, polycrystalline semiconductor materials, oxide semiconductor materials, or two-dimensional materials.

12. The three-dimensional semiconductor device of any one of claims 1 to 11, further comprising a data storage pattern (DSP), which is on a second side surface (S2) of the semiconductor pattern (SP) opposite to the first side surface (S1).

13. The three-dimensional semiconductor device of any one of claims 1 to 12 , wherein the metal liner pattern has a U-shaped structure.

14. The three-dimensional semiconductor device of any one of claims 1 to 13, wherein the material in the gate electrode pattern (GEP) has a uniform and continuous orientation.

15. A method of fabricating a three-dimensional semiconductor device as claimed in claim 1, wherein the gate electrode pattern (GEP) is formed by a selective growth process.
